(19) **Europäisches Patentamt**
**European Patent Office**
**Office européen des brevets**

(11) **EP 3 872 503 B1**

(12) **EUROPÄISCHE PATENTSCHRIFT**

(45) Veröffentlichungstag und Bekanntmachung des Hinweises auf die Patenterteilung:
**19.10.2022 Patentblatt 2022/42**

(21) Anmeldenummer: **21157668.1**

(22) Anmeldetag: **17.02.2021**

(51) Internationale Patentklassifikation (IPC):
**G01R 27/22** (2006.01)   **G01R 27/18** (2006.01)
**G01R 31/08** (2020.01)   **G01R 31/50** (2020.01)
**G01R 31/52** (2020.01)

(52) Gemeinsame Patentklassifikation (CPC):
**G01R 27/22; G01R 27/18; G01R 31/085; G01R 31/52**

(54) **ÜBERWACHUNGSVORRICHTUNG UND VERFAHREN ZUR ISOLATIONSÜBERWACHUNG EINES UNGEERDETEN ELEKTRISCHEN SYSTEMS MIT GEERDET BETRIEBENER FLÜSSIGKEITSKÜHLUNG**

MONITORING DEVICE AND METHOD FOR MONITORING THE INSULATION OF AN UNSHIELDED ELECTRICAL SYSTEM WITH GROUNDED LIQUID COOLING

DISPOSITIF DE SURVEILLANCE ET PROCÉDÉ DE SURVEILLANCE D'ISOLATION D'UN SYSTÈME ÉLECTRIQUE NON MIS À LA TERRE POURVU DE REFROIDISSEMENT LIQUIDE MIS À LA TERRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.02.2020 DE 102020104956**

(43) Veröffentlichungstag der Anmeldung:
**01.09.2021 Patentblatt 2021/35**

(73) Patentinhaber: **Bender GmbH & Co. KG**
**35305 Grünberg (DE)**

(72) Erfinder: **HACKL, Dieter**
**35463 Fernwald (DE)**

(74) Vertreter: **advotec.**
**Patent- und Rechtsanwaltspartnerschaft**
**Tappe mbB**
**Georg-Schlosser-Straße 6**
**35390 Gießen (DE)**

(56) Entgegenhaltungen:
**DE-A1-102016 009 346    JP-A- 2010 164 531**
**US-A1- 2009 096 464**

**Beschreibung**

Die Erfindung betrifft eine Überwachungsvorrichtung zur Überwachung eines Isolationswiderstands für ein ungeerdetes elektrisches System, welches eine mit einem Kühlmittel geerdet betriebene Flüssigkeitskühlung mit einer Zuleitung und einer Rückleitung aufweist, wobei die Zuleitung und die Rückleitung jeweils als ein mit Erdpotential verbundener elektrisch leitfähiger Rohrleitungsabschnitt ausgeführt sind, an den sich ein mit dem elektrischen System verbundener elektrisch isolierter Rohrleitungsabschnitt mit der Rohrleitungslänge li anschließt.

Bei erhöhten Anforderungen an die Betriebs-, Brand- und Berührungssicherheit kommt die Netzform eines ungeerdeten elektrischen Systems zum Einsatz, die auch als isoliertes System (frz. Isole Terre - IT) oder IT-System bezeichnet wird. Bei dieser Art des Systems sind sämtliche aktiven Teile von dem Erdpotential - gegenüber Erde - getrennt. Der Vorteil eines solchen ungeerdeten elektrischen Systems liegt darin, dass bei einem Isolationsfehler die Funktion des elektrischen Systems nicht beeinträchtigt wird, da sich wegen des im Idealfall unendlich großen Impedanzwertes zwischen dem elektrischen System und Erde kein geschlossener Stromkreis ausbilden kann. Allerdings muss der Widerstand des ungeerdeten elektrischen Systems gegen Erde (Isolationswiderstand) ständig überwacht werden, da bei Auftreten eines weiteren Fehlers möglicherweise eine Fehlerschleife entstehen könnte und der dabei fließende Fehlerstrom in Verbindung mit einer Überstromschutzeinrichtung eine Abschaltung des elektrischen Systems mit Betriebsstillstand zur Folge hätte.

Die Isolationsüberwachung wird dem Stand der Technik entsprechend mit einem Isolationsüberwachungsgerät durchgeführt, welches zwischen einen aktiven Leiter des elektrischen Systems und Erde geschaltet ist, dem zu überwachenden elektrischen System eine Messspannung als Messsignal überlagert und einen über den Isolationswiderstand fließenden Fehlerstrom zur Bestimmung des Isolationswiderstands auswertet.

Umfassen die zu überwachenden elektrischen Systeme eine Leistungselektronik, wie das beispielsweise bei zahlreichen Stromrichteranwendungen mit ihren Leistungshalbleitern der Fall ist, so wird die in dem elektrischen System entstehende Wärme wirkungsvoll über ein Flüssigkeitskühlsystem abgeführt. Als Kühlflüssigkeit wird bevorzugt demineralisiertes Wasser eingesetzt. Die Kühlmittelumwälzpumpe und die Kühlmittelaufbereitung werden überwiegend von einem Stromversorgungssystem mit einer geerdeten Netzform (geerdetes Stromversorgungssystem) gespeist und sind daher mit Erdpotential verbunden. Meistens existiert auch eine direkte Verbindung des Kühlmittelsystems mit dem geerdeten Trinkwasserleitungssystem, um einen Kühlmittelverlust schnell ausgleichen zu können.

Um das kühlungsbedürftige elektrische System, beispielsweise einen Stromrichter, ungeerdet betreiben zu können und gleichzeitig das Flüssigkeitskühlsystem mit einem geerdeten Stromversorgungssystem versorgen zu können, ist es bekannt, das geerdete Kühlsystem von dem ungeerdeten elektrischen System über elektrisch isolierte Kühlmittelrohre oder Rohrleitungsabschnitte elektrisch zu separieren.

Eine vollständige galvanische Trennung zwischen dem ungeerdeten elektrischen System und der geerdet betriebenen Flüssigkeitskühlung ist allerdings wegen der praktisch immer vorhandenen und prozessbedingt schwankenden elektrolytischen Leitfähigkeit der Kühlflüssigkeit nicht gegeben. Diese unvollständige elektrische Trennung zwischen dem ansonsten isoliert aufgebauten ungeerdeten elektrischen System und der geerdet betriebenen Flüssigkeitskühlung kann durch einen Kühlmittelwiderstand $R_K$ modelliert werden.

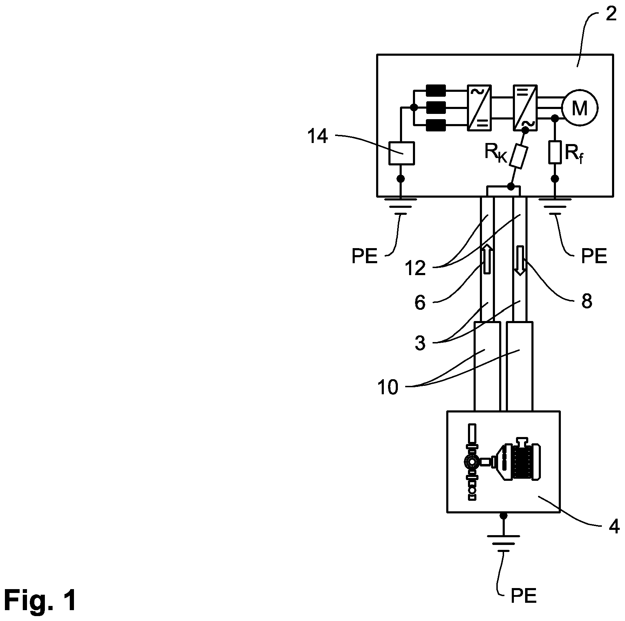

**Fig. 1** zeigt die der Erfindung zugrunde liegende Problemstellung. Ein ungeerdetes elektrisches System 2, hier beispielhaft dargestellt durch einen Stromrichter mit flüssigkeitsgekühlter Leistungselektronik, ist mit einer geerdet betriebenen Flüssigkeitskühlung verbunden. Die Flüssigkeitskühlung umfasst einen Kühlmittelantrieb 4, der über eine Zuleitung 6 und eine Rückleitung 8, in denen das Kühlmittel 3 fließt, mit dem zu kühlenden elektrischen System 2 verbunden ist. Sowohl die Zuleitung 6 als auch die Rückleitung 8 bestehen jeweils aus einem elektrisch leitfähigen Rohrleitungsabschnitt 10, der mit dem Erdpotential PE verbunden ist. An den elektrisch leitfähigen Rohrleitungsabschnitt 10 schließt sich - jeweils für die Zuleitung 6 und die Rückleitung 8 - in Richtung des elektrischen Systems 2 ein elektrisch isolierter Rohrleitungsabschnitt 12 an, der an dem elektrischen System 2 mündet.

Zur Überwachung des Isolationswiderstands $R_f$ des elektrischen Systems 2 ist das elektrische System 2 vorschriftsgemäß mit einem Isolationsüberwachungsgerät 14 ausgestattet.

Die elektrolytische Leitfähigkeit des Kühlmittels ist durch den Kühlmittelwiderstand $R_K$ als konzentriertes Element dargestellt und liegt parallel zu dem Isolationswiderstand $R_f$. Nimmt der Kühlmittelwiderstand $R_K$ bei zu hoher Leitfähigkeit des Kühlmittels 3 im Vergleich zu dem Isolationswiderstand Rf einen unzulässig kleinen Wert ein, so ist eine normgerechte Überwachung des elektrischen Systems 2 mit dem Isolationsüberwachungsgerät 14 nicht mehr zuverlässig möglich. Liegt der Kühlmittelwiderstand $R_K$ mit durchaus üblichen Werten von einigen wenigen kΩ parallel zu einem (System-)Isolationswiderstand $R_f$, der ein hohes Isolationsniveau, von z.B. einem MΩ aufweist, so müsste das Isolationsüberwachungsgerät trotz gutem Isolationszustand des elektrischen Systems 2 aufgrund des niedrigen Kühlmittelwiderstands $R_K$ dauerhaft einen Alarm ausgeben, um den normativen Anforderungen gerecht zu werden.

Aus diesen Überlegungen wird deutlich, dass eine normgerechte Überwachung nicht möglich ist.

Diese Problemstellung verschärft sich, wenn aus Kostengründen mehrere ungeerdete elektrische Subsysteme 16, beispielsweise mehrere leistungsstarke Stromrichter, von einem gemeinsamen ungeerdeten Transformator 15 gespeist werden.

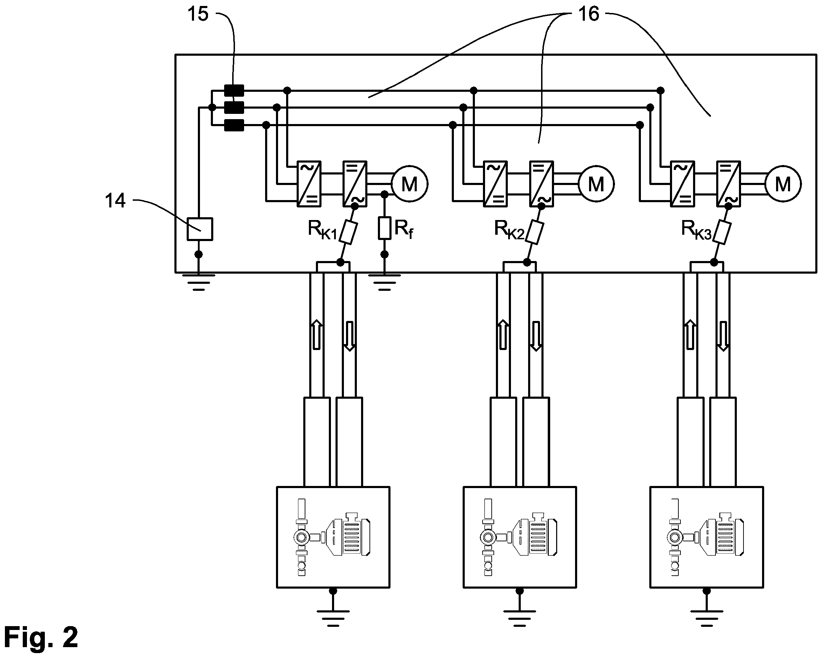

**Fig. 2** zeigt eine derartige Konstellation, bei der beispielhaft drei ungeerdete elektrische Subsysteme 16 von einem gemeinsamen Transformator 15 gespeist werden. Vorausgesetzt, dass die Geometrie der Kühlmittelzuführung und die elektrolytische Leitfähigkeit des Kühlmittels 3 in allen drei elektrischen Subsystemen 16 gleich sind, ergibt sich für den Gesamtkühlmittelwiderstand in etwa ein Drittel des Wertes des Kühlmittelwiderstands $R_K$ aus Fig. 1. Der dadurch entstehende systematische Fehler bei der Bestimmung des Isolationswiderstands Rf mit einem Isolationsüberwachungsgerät 14 wird inakzeptabel groß.

Zur Lösung des Problems kann dem Stand der Technik gemäß bei der Systemplanung durch konstruktive Maßnahmen dafür gesorgt werden, dass der Kühlmittelwiderstand groß genug wird, um den systematischen Fehler bei der Isolationsüberwachung entsprechend den normativen Anforderungen klein zu halten. Bekannte Maßnahmen sind beispielsweise eine entsprechende Ausgestaltung der Geometrie der Kühlmittelzuführung, die Verwendung sehr hochwertiger Materialien, um Korrosions-und/oder Migrationseffekte bei der Verwendung von Kühlmitteln mit sehr niedrigen Leitwerten gering zu halten.

Diese konstruktiven Maßnahmen führen jedoch zu deutlich erhöhten Systemkosten, sodass in der Praxis die Ansprechwerte des Isolationsüberwachungsgerätes für den Vor- und den Hauptalarm deutlich abweichend von den normativen Empfehlungen auf ein sehr niederohmiges Niveau gesetzt werden. Messtechnisch arbeiten daher die Isolationsüberwachungsgeräte in diesem Umfeld häufig in einem Grenzbereich und außerhalb ihrer technischen Spezifikation. Für den Anwender bedeutet dies auch eine Häufung von Fehlalarmmeldungen. Der Stand der Technik findet sich zum Beispiel in den Dokumenten DE102016009346, US2009096464 und JP2010164531.

Der vorliegenden Erfindung liegt somit die Aufgabe zugrunde, für ein ungeerdetes elektrisches System, welches mit einer geerdet betriebenen Flüssigkeitskühlung betrieben wird, eine Überwachungsvorrichtung sowie ein Verfahren zur Überwachung des Isolationswiderstands vorzuschlagen, die eine zuverlässige und kosteneffiziente Überwachung des Isolationswiderstands ermöglichen.

Diese Aufgabe wird bezogen auf eine Vorrichtung durch die kennzeichnenden Merkmale des Anspruchs 1 gelöst.

Der erfinderische Grundgedanke liegt nun darin, dass die Einspeisung eines Messsignales zur Bestimmung des Isolationswiderstands seriell über den Kühlmittelwiderstand erfolgt. Im Gegensatz zu dem Stand der Technik, bei dem eine Ankopplung des Messsignales an einen aktiven Leiter gegen Erde parallel zu dem Kühlmittelwiderstand $R_K$ erfolgt, liegt bei der erfindungsgemäßen Konstellation der Kühlmittelwiderstand $R_K$ nicht parallel zu dem zu ermittelnden Isolationswiderstand Rf, sondern ist zu diesem in Reihe geschaltet. Der oben beschriebene systematische Fehler entfällt dadurch.

Die Überwachungsvorrichtung weist daher je nach Art der Einkopplung des Messsignals - eine gemeinsame Einkopplung über die Zuleitung und die Rückleitung oder eine einseitige Einkopplung nur in die Zuleitung oder in die Rückleitung - eine oder zwei niederohmige Messsignalquellen auf, die jeweils ein Messsignal in Form einer Messspannung erzeugen. Die Messsignalquelle(n) ist/sind über einen Erdpotentialanschluss mit dem elektrisch leitfähigem Rohrleitungsabschnitt oder allgemein mit dem Erdpotential kontaktiert.

Zur Einkopplung des Messsignales ist ein Einkopplungsanschluss der Messsignalquelle mit einem leitfähigen, das Kühlmittel kontaktierenden Einkopplungsrohrelement verbunden.

Zur Messung eines Ankoppelstroms, welcher in dem durch den elektrisch isolierten Rohrleitungsabschnitt strömenden Kühlmittel fließt, ist ein Ankoppelstrom-Messsensor an dem elektrisch isolierten Rohrleitungsabschnitt angeordnet.

Dem Ankoppelstrom-Messsensor ist in Richtung des elektrischen Systems ein Fehlerstrom-Messsensor nachgeschaltet. Dieser dient zur Messung eines Fehlerstroms, welcher sich ebenfalls in dem durch den elektrisch isolierten Rohrleitungsabschnitt strömenden Kühlmittel ausbildet und zur Bestimmung des Isolationswiderstands herangezogen wird.

Auf dem elektrisch isoliertem Rohrleitungsabschnitt ist das (einteilige) Einkopplungs-Rohrelement zwischen dem erdpotentialseitig angeordneten Ankoppelstrom-Messsensor und dem systemseitig befindlichen Fehlerstrom-Messsensor so angeordnet - bzw. sind bei zweiteiliger Einkopplung beide Einkopplungs-Rohrelemente so angeordnet -, dass die Rohrleitungslänge des elektrisch isolierten Rohrleitungsabschnitts in eine sich zwischen dem elektrisch leitfähigen Rohrleitungsabschnitt und dem Einkopplungs-Rohrelement erstreckende Ankopplungslänge und eine sich von dem Einkopplungs-Rohrelement bis zu dem elektrischen System erstreckende Widerstandslänge geteilt ist.

Zur Berechnung des Isolationswiderstands aus der Messspannung, dem erfassten Ankopplungsstrom, dem erfassten Fehlerstrom, der Ankopplungslänge und der Widerstandslänge weist die Überwachungsvorrichtung eine Recheneinheit, beispielsweise in Form eines Mikroprozessors auf.

Ausgehend von dem von einem geerdeten Stromversorgungssystem gespeisten Kühlmittelantrieb und daran angeschlossenen elektrisch leitfähigen Rohrleitungsabschnitten ist die Reihenfolge der Anordnung der Elemente Ankoppelstrom-Messsensor, Einkopplungs-Rohrelement und Fehlerstrom-Messsensor stets gleich, die Konstruktion zur Anbringung dieser Elemente an der Zuleitung bzw. der Rückleitung kann sich jedoch unterscheiden.

In einer möglichen Ausgestaltung weist der Fehlerstrom-Messsensor einen Fehlerstrom-Messstromwandler auf, der gemeinsam die Zuleitung und die Rückleitung umschließt. Ebenso weist der Ankoppelstrom-Messsensor einen Ankoppelstrom-Messstromwandler auf, der gemeinsam die Zuleitung und die Rückleitung umschließt.

Das Einkopplungs-Rohrelement ist entweder einteilig ausgeführt und mit der Messsignalquelle verbunden, sodass das Messsignal gemeinsam in die Zuleitung und die Rückleitung synchron im Gleichtakt eingekoppelt wird oder das Einkopplungs-Rohrelement ist zweiteilig ausgeführt und besteht aus einem Zuleitungs-Einkopplungs-Rohrelement und einem Rückleitungs-Einkopplungs-Element. Letztere beiden Elemente sind jeweils mit einer der Messsignalquellen verbunden und koppeln die jeweiligen Messsignale jeweils einseitig in die Zuleitung und die Rückleitung synchron im Gleichtakt ein. Die Messsignaleinkopplung erfolgt somit immer in die Zuleitung und die Rückleitung.

Der Fehlerstrom-Messsensor weist einen Fehlerstrom-Messstromwandler und der Ankoppelstrom-Messsensor weist einen Ankoppelstrom-Messstromwandler auf, wobei der Fehlerstrom-Messstromwandler und der Ankoppelstrom-Messstromwandler beide einseitig die Zuleitung oder beide einseitig die Rückleitung umfassen.

Besonders vorteilhaft gestaltet sich die Verwendung der erfindungsgemäßen Überwachungsvorrichtung zur Überwachung des Isolationswiderstandes für ein elektrisches System, welches ein ungeerdetes Stromrichtersystem ist.

Insbesondere leistungsstarke Stromrichtersysteme (Wechsel-, Gleich-und Umrichtersysteme), die einer hohen Kühlleistung bedürfen, können mit der erfindungsgemäßen Überwachungsvorrichtung zuverlässig im Hinblick auf den Isolationswiderstand überprüft werden.

Eine verbleibende Messunsicherheit bei der galvanisch getrennten Strommessung über den Fehlerstrom-Messsensor und den Ankoppelstrom-Messsensor kann durch die Ermittlung eines Messstroms über den Spannungsabfall an einen Bürdenwiderstand in der Messspannungsquelle verringert werden. Aus dieser Überlegung heraus ergibt sich ein zu der Strommessung alternativer erfindungsgemäßer Ansatz mit einer Spannungsmessung, der jedoch bekannte und stabile Geometrieverhältnisse der Kühlmittelzuführung voraussetzt.

Die der Erfindung zugrunde liegende Aufgabe wird somit weiterhin gelöst durch eine Überwachungsvorrichtung gemäß den Merkmalen nach Anspruch 5.

Auch in dieser Ausführungsform weist die Überwachungseinrichtung eine niederohmige Messsignalquelle zur Erzeugung eines Messsignals mit einer Messspannung auf. Die Messsignalquelle umfasst einen Erdpotentialanschluss, der mit dem elektrisch leitfähigen Rohrleitungsabschnitt verbunden ist, sowie einen Einkopplungsanschluss. Mit diesem Einkopplungsanschluss der Messsignalquelle ist ein leitfähiges, das Kühlmittel kontaktierende Einkopplungs-Rohrelement verbunden, welches das Messsignal im Gleichtakt in die Zuleitung und die Rückleitung synchron einkoppelt.

Diese Ausführungsform der Überwachungsvorrichtung weist im Gegensatz zu der im Anspruch 1 beschriebenen Überwachungsvorrichtung keine Strommessung auf, sondern umfasst stattdessen einen Spannungsmesser und ein leitfähiges, das Kühlmittel kontaktierende Spannungsmess-Rohrelement zur Messung einer Teilspannung auf dem elektrisch isolierten Rohrleitungsabschnitt auf.

Ein erster Spannungsmesseingang des Spannungsmessers ist mit dem Einkopplungsanschluss der Messsignalquelle verbunden, ein zweiter Spannungsmesseingang des Spannungsmessers ist zur Erfassung der Teilspannung mit dem Spannungsmess-Rohrelement verbunden.

Das Einkopplungs-Rohrelement ist auf den elektrisch isolierten Rohrleitungsabschnitten so angeordnet, dass sich zwischen dem systemseitigen Ende der erdpotentialseitig angeordneten elektrisch leitfähigen Rohrleitungsabschnitte und dem Einkopplungs-Rohrelement eine bestimmte Ankopplungslänge auf den elektrisch isolierten Rohrleitungsabschnitten ergibt. Daran anschließend in Richtung des elektrischen Systems ist das Spannungsmess-Rohrelement auf den elektrisch isolierten Rohrleitungsabschnitten so angeordnet, dass sich zwischen dem Einkopplungs-Rohrelement und dem Spannungsmess-Rohrelement ein Abstand mit einer definierten Spannungsmesslänge einstellt. Zwischen dem Spannungsmessrohrelement und dem elektrischen System ergibt sich eine definierte Widerstandslänge auf den elektrisch isolierten Rohrleitungsabschnitten.

Auch die Überwachungsvorrichtung in dieser Ausführungsform mit Spannungsmessung weist eine Recheneinheit auf, die zur Berechnung des Isolationswiderstands aus der Messspannung, dem Messsignal, einem eingespeisten Messstrom, der Teilspannung, der Ankopplungslänge, der Spannungsmesslänge und der Widerstandslänge ausgelegt ist.

Vorteilhaft ist die Verwendung der Überwachungsvorrichtung zur Überwachung des Isolationswiderstands für ein ungeerdetes Stromrichtersystem als elektrisches System, um insbesondere bei leistungsstarken Stromrichtersystemen dem Kühlbedarf gerecht zu werden.

Ausgehend von der Überwachungsvorrichtung mit Strommessung (Anspruch 1) und der Ausführung der Überwachungsvorrichtung mit Spannungsmessung (Anspruch 5) wird eine erweiterte Überwachungsvorrichtung zur Überwachung eines gemeinsamen Isolationswiderstands mehrerer von einem gemeinsamen Transformator gespeister, ungeerdeter elektrischer Subsysteme konzipiert.

Die jeweiligen elektrischen Subsysteme entsprechen dabei unter Einbeziehung des gemeinsamen Transformators dem oben genannten ungeerdeten elektrischen System, welches jeweils eine mit einem Kühlmittel geerdet betriebe Flüssigkeitskühlung mit einer Zuleitung und einer Rückleitung aufweist.

**EP 3 872 503 B1**

Erfindungsgemäß sind in der erweiterten Überwachungsvorrichtung mindestens zwei der ungeerdeten elektrischen Subsysteme mit einer Überwachungsvorrichtung nach einem der Ansprüche 1 bis 6 ausgestattet.

Die erweiterte Überwachungsvorrichtung weist weiterhin eine Synchronisations-Steuereinrichtung zur synchronen Einkopplung der Messsignale in die jeweiligen zu überwachenden elektrischen Subsysteme auf.

Damit ist ein zeitlich synchroner Messsignalverlauf der von den Messsignalquellen erzeugten und in das jeweilige Subsystem eingespeisten Messsignale gewährleistet.

Mit Vorteil weist die Synchronisations-Steuereinrichtung eine Amplituden-Steuereinrichtung zur Steuerung der Messsignalamplituden der in den jeweiligen Überwachungsvorrichtungen erzeugten Messsignale auf.

Die Steuerung der Messsignalamplituden in den jeweiligen den elektrischen Subsystemen zugeordneten Überwachungsvorrichtungen ist nicht unbedingt erforderlich, kann aber bei sehr ungleicher geometrischer Aufteilung der Kühlmittelzuführung dazu genutzt werden, auftretende Ableitströme gegen Erde oder Verlagerungsspannungen gegen Erde für jedes elektrische Subsystem möglichst gleich einzustellen. Hierdurch wird eine ungleiche Strom- und Spannungsbelastung einzelner elektrischer Subsysteme vermieden, denn eine extreme Abweichung der Ableitströme in den einzelnen elektrischen Subsystemen kann dazu führen, dass ein zusätzlicher systematischer Messfehler dadurch entsteht, dass die jeweiligen Messsignalquellen und/oder Stromsensoren in einen ungünstigen Arbeitsbereich gelangen.

In vorteilhafter Weise kann mit der Amplituden-Steuereinrichtung die Messsignalamplitude für jedes zu überwachende elektrische Subsystem gesteuert werden, sodass die Gesamtbetriebsmesssicherheit des Isolationsüberwachungssystems weitgehend unabhängig von prozesstechnisch zu erwartenden Schwankungen von Parametern des Kühlmittelsystems (z.B. Schwankung der elektrolytischen Leitfähigkeit) und den zu erwartenden Unterschieden in der geometrischen Konstruktion des Kühlmittelkreislaufs (z.B. unterschiedliche Längen der Kühlmittelrohre) erhöht wird.

Die Ausführungen der zuvor beschriebenen erfindungsgemäßen Überwachungsvorrichtungen beruhen auf der in den unabhängigen Verfahrensansprüchen 9, 11 und 13 beschriebenen technischen Lehren. Insoweit treffen auch die vorgenannten technischen Wirkungen und die daraus entstehenden Vorteile auf die in den Verfahrensansprüchen aufgeführten Merkmale zu.

Insbesondere können in vorteilhafter Weise systembedingt durch die Konstruktion der Kühlmittelzufuhr vorhandene Einkopplungsmöglichkeiten bei flüssigkeitsgekühlten Stromrichteranwendungen genutzt werden und dadurch eine messtechnische Optimierung durch Vermeidung eines parallel zu dem Isolationswiderstand liegenden Kühlmittelwiderstands gegen Erde erreicht werden.

Mit Vorteil kann die in einem Isolationsüberwachungsgerät umgesetzte Leistung und dessen Spannungsbelastung auch bei Mittelspannungsanwendungen reduziert werden.

Weitere vorteilhafte Ausgestaltungmerkmale ergeben sich aus der nachfolgenden Beschreibung und den Zeichnungen, die bevorzugte Ausführungsformen der Erfindung anhand von Beispielen erläutern.

Es zeigen:

**Fig. 1**    Ein ungeerdetes elektrisches System mit geerdet betriebener Flüssigkeitskühlung;

**Fig. 2**    von einem gemeinsamen Transformator gespeiste ungeerdete elektrische Subsysteme;

**Fig. 3**    eine erfindungsgemäße Überwachungsvorrichtung mit gemeinsamer Strommessung und einteiliger Messsignaleinkopplung;

**Fig. 4**    eine erfindungsgemäße Überwachungsvorrichtung mit einseitiger Strommessung und einteiliger Messsignaleinkopplung;

**Fig. 5**    eine erfindungsgemäße Überwachungsvorrichtung mit gemeinsamer Strommessung und zweiteiliger Messsignaleinkopplung;

**Fig. 6**    ein Ersatzschaltbild zur Bestimmung des Isolationswiderstands nach Fig. 3;

**Fig. 7**    eine erfindungsgemäße Überwachungsvorrichtung mit Spannungsmessung;

**Fig. 8**    ein Ersatzschaltbild zur Bestimmung des Isolationswiderstands nach Fig. 7;

**Fig. 9**    eine erfindungsgemäße erweiterte Überwachungsvorrichtung mit Strommessung;

**Fig. 10**    ein Ersatzschaltbild zur Bestimmung des Isolationswiderstands nach Fig. 9;

**Fig. 11**    eine erweiterte Überwachungsvorrichtung mit Spannungsmessung;

**Fig. 12**     ein Ersatzschaltbild zur Bestimmung des Isolationswiderstands nach Fig. 11.

**Fig. 1** zeigt zur Verdeutlichung der Problemstellung ein ungeerdetes elektrisches System 2, welches eine mit einem Kühlmittel 3 geerdet betriebene Flüssigkeitskühlung mit einer Zuleitung 6 und einer Rückleitung 8 aufweist.

An einen Kühlmittelantrieb 4 (erdpotentialseitig) ist mit dem Erdpotential PE verbunden für die Zuleitung 6 und die Rückleitung 8 des Kühlmittels 3 jeweils ein elektrisch leitfähiger Rohrleitungabschnitt 10 angeordnet, an den sich (systemseitig) ein elektrisch isolierter Rohrleitungsabschnitt 12 anschließt, der an dem ungeerdeten elektrischen System 2 mündet.

Um den Isolationswiderstand $R_f$ des elektrischen Systems 2 zwischen einem oder mehreren aktiven Leitern gegen Erde PE zu bestimmen, ist dem Stand der Technik gemäß ein Isolationsüberwachungsgerät 14 zwischen das ungeerdete elektrische System 2 und Erde PE geschaltet.

In Folge der elektrolytischen Leitfähigkeit des Kühlmittels 3 ist das elektrische System 2 nicht vollständig gegen Erde PE elektrisch isoliert. Es besteht somit gegen Erde PE eine elektrisch leitfähige Verbindung, die hier durch den Kühlmittelwiderstand $R_K$ als konzentriertes Element modelliert ist. Dieser Kühlmittelwiderstand $R_K$ liegt parallel zu dem zu ermittelnden Isolationswiderstand $R_f$ und beeinflusst die Messung des Isolationswiderstandes erheblich.

**Fig. 2** zeigt die Anordnung von drei elektrischen Subsystemen 16, die von einem gemeinsamen Transformator 15 gespeist werden. Infolge der Parallelschaltung der elektrischen Subsysteme 16 verringert sich der Gesamtkühlmittelwiderstand auf etwa ein Drittel und führt somit zu einer noch ungenaueren Bestimmung des Isolationswiderstands Rf.

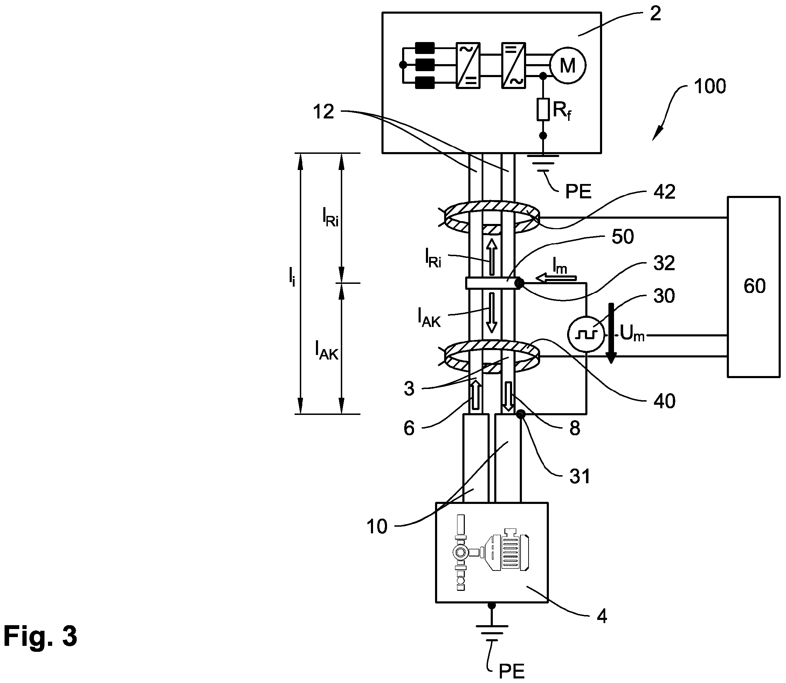

**Fig. 3** zeigt eine erfindungsgemäße Überwachungsvorrichtung 100 mit gemeinsamer Strommessung und einteiliger Messsignaleinkopplung in der Anwendung für ein in der Fig. 1 dargestelltes ungeerdetes elektrisches System 2 mit geerdet betriebener Flüssigkeitskühlung.

An dem elektrisch isolierten Rohrleitungsabschnitt 12 mit der Rohrleitungslänge $l_i$ ist erdpotentialseitig ein Ankoppelstrom-Messsensor 40 angeordnet, dessen Ankoppelstrom-Messstromwandler gemeinsam die Zuleitung 6 und die Rückleitung 8 umschließt. Der Ankoppelstrom-Messsensor 40 erfasst einen Ankoppelstrom $I_{AK}$, welcher in dem durch den elektrisch isolierten Rohrleitungsabschnitt 12 strömenden Kühlmittel 3 fließt.

In Richtung des elektrischen Systems 2 dem Ankoppelstrom-Messsensor 40 nachgeschaltet ist ein Fehlerstrom-Messsensor 42, der ebenfalls die Zuleitung 6 und die Rückleitung 8 gemeinsam umschließt und der einen Fehlerstrom $I_{Ri}$ erfasst, welcher sich - in der Darstellung "oberhalb" der Messsignaleinkopplung - in dem durch den elektrisch isolierten Rohrleitungsabschnitt 12 strömenden Kühlmittel 3 einstellt.

Zwischen dem Ankoppelstrom-Messsensor 40 und dem Fehlerstrom-Messsensor 42 ist im Abstand einer Ankopplungslänge $l_{AK}$ - gemessen von dem (systemseitigen Ende des) elektrisch leitfähigen Rohrleitungabschnitts 10 - ein einteiliges Einkopplungs-Rohrelement 50 in dem elektrisch isolierten Rohrleitungsabschnitt 12 angebracht. Von dem Einkopplungs-Rohrelement 50 bis zum Anschluss des elektrisch isolierten Rohrleitungsabschnitts 12 an das elektrische System 2 verbleibt eine Widerstandslänge $l_{Ri}$, die zusammen mit der Ankopplungslänge $l_{AK}$ die Rohrleitungslänge li des elektrisch isolierten Rohrleitungsabschnitts 12 ergibt.

Zur Einspeisung eines Messsignals (Messspannung $U_m$) ist das einteilige Einkopplungs-Rohrelement 50 mit einer Messspannungsquelle 30 über einen Einkopplungsanschluss 32 verbunden. Ein Erdpotentialanschluss 31 der Messsignalquelle 30 liegt auf Erdpotential PE, beispielsweise verbunden mit dem elektrisch leitfähigen Rohrleitungsabschnitt 10.

Zur Berechnung des Isolationswiderstands Rf weist die Überwachungsvorrichtung 100 eine Recheneinheit 60 auf, die die Ausgangssignale des Ankoppelstrom-Messsensors 40, des Fehlerstrom-Messsensors 42 und der Messsignalquelle 30 auswertet.

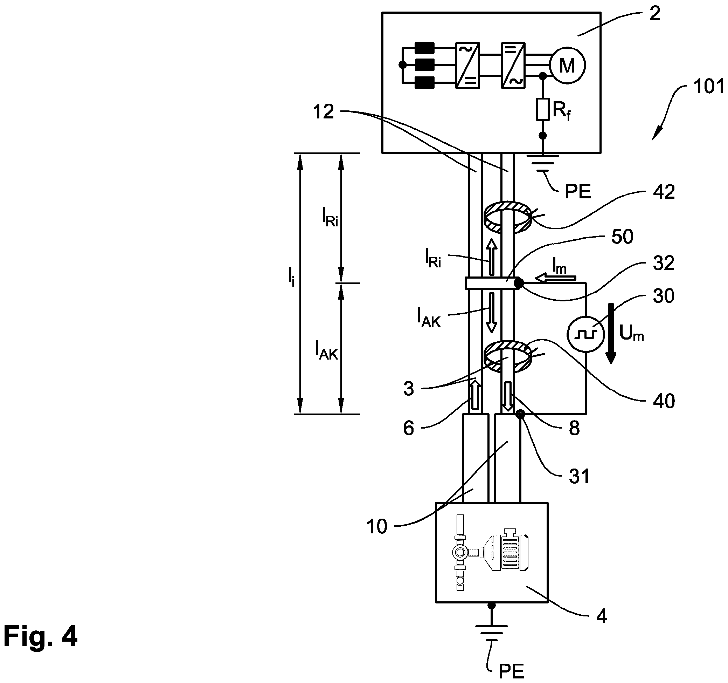

**Fig. 4** zeigt eine Ausführungsform der erfindungsgemäßen Überwachungsvorrichtung 101 mit einseitiger Strommessung und einteiliger Messsignaleinkopplung.

Im Unterschied zu der in Fig. 3 dargestellten Ausführung sind hier der Ankoppelstrom-Messsensor 40 und der Fehlerstrom-Messsensor 42 einseitig ausgeführt, also beide Messstromwandler entweder einseitig um die Zuleitung 6 oder beide einseitig um die Rückleitung 8 angeordnet.

Die Überwachungsvorrichtung 101 weist in gleicher Weise wie die in Fig. 3 gezeigte Überwachungsvorrichtung 100 eine in Fig. 4 nicht dargestellte Recheneinheit 60 auf.

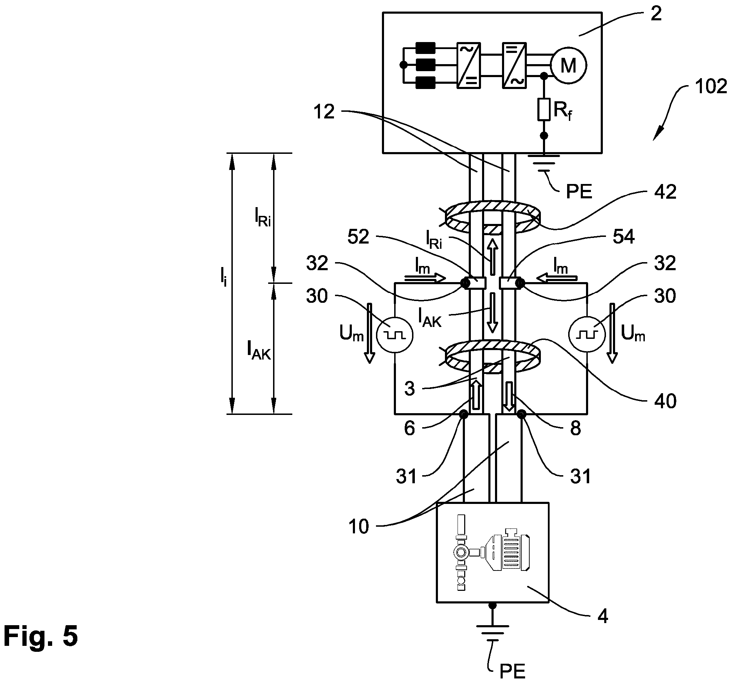

**Fig. 5** zeigt eine weitere Ausführung der Überwachungsvorrichtung 102 mit gemeinsamer Strommessung und zweiteiliger Messsignaleinkopplung.

Die Strommessung erfolgt wie bei der in Fig. 3 gezeigten Überwachungsvorrichtung 100 mit einem erdpotentialseitig angeordneten Ankoppelstrom-Messsensor 40 und einem systemseitig angeordneten Fehlerstrom-Messsensor 42, die jeweils die Zuleitung 6 und die Rückleitung 8 gemeinsam umschließen.

Das Einkopplungs-Rohrelement 50 ist jedoch zweiteilig in ein Zuleitungs-Einkopplungs-Rohrelement 52 und ein Rückleitungs-Einkopplungs-Rohrelement 54 geteilt. Das Zuleitungs-Einkopplungs-Rohrelement 52 und das Rückleitungs-Einkopplungs-Rohrelement 54 sind jeweils mit einer Messsignalquelle 30 verbunden, wobei die jeweiligen Messsignale einseitig jeweils in die Zuleitung 6 und die Rückleitung 8 synchron im Gleichtakt eingekoppelt werden.

Würde die Einkopplung des Messsignals nicht synchron im Gleichtakt gegen Erde in die Zuleitung 6 und die Rückleitung 8 erfolgen, beispielsweise nur in die Zuleitung 6, so würden elektrische Ableitströme über die Kühlmittelrückleitung wieder als elektrischer Widerstand parallel zu dem bestimmenden Isolationswiderstand Rf liegen. Das zugrundeliegende Problem wäre damit nicht gelöst.

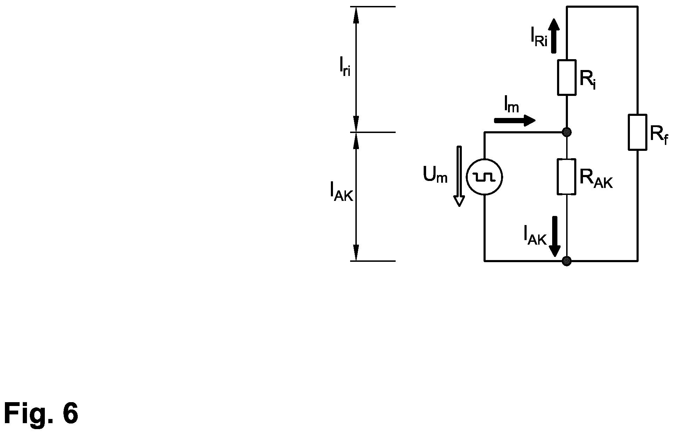

In **Fig. 6** ist ein aus der Überwachungsvorrichtung 100 nach Fig. 3 abgeleitetes elektrisches Ersatzschaltbild zur Bestimmung des Isolationswiderstandes Rf dargestellt.

Der in Fig. 1 modellierte Kühlmittelwiderstand $R_K$ wird hier durch einen Ankoppelwiderstand $R_{AK}$ und einen Innenwiderstand Ri repräsentiert. Der Ankoppelwiderstand $R_{AK}$ ergibt sich demnach aus dem Quotienten der Amplituden des synchron eingeprägten Messsignales $U_m$ und dem von dem Ankoppelstrom-Messsensor 40 erfassten Ankoppelstrom $I_{AK}$ zu

$$R_{AK} = \frac{U_m}{I_{AK}}.$$

Ausgehend von einem konstanten Querschnitt der Kühlmittelzuführung und einer entlang der Kühlmittelzuführung konstanten elektrolytischen Leitfähigkeit des Kühlmittels 3 kann der Innenwiderstand Ri aus dem zuvor ermittelten Wert des Ankoppelwiderstands $R_{AK}$ und dem Verhältnis der Widerstandslänge $l_{Ri}$ zu der Ankopplungslänge $l_{AK}$ in dem elektrisch isolierten Rohrleitungsabschnitt 12 wie folgt bestimmt werden

$$R_i = R_{AK} * \frac{l_{Ri}}{l_{AK}}$$

Erfindungsgemäß werden damit Schwankungen der elektrolytischen Leitfähigkeit des Kühlmittels 3 über die Änderung des Innenwiderstands Ri erkannt und können bei der Bestimmung des Isolationswiderstands Rf berücksichtigt werden. Ein systematischer Messfehler wird dadurch vermieden.

Zu bemerken ist, dass in dem elektrischen Ersatzschaltbild das in der Zuleitung 6 und der Rückleitung 8 strömende Kühlmittel 3 in seiner elektrischen Wirkung als ein (einziger) Widerstand Ri bzw. ein (einziger) Ankoppelwiderstand $R_K$ dargestellt ist.

Ausgehend von dem elektrischen Ersatzschaltbild lässt sich mit der Stromteilerregel der Isolationswiderstand Rf wie folgt bestimmen

$$R_f = \frac{U_m}{I_{AK}} * \left( \frac{I_{AK}}{I_{Ri}} - \frac{l_{Ri}}{l_{AK}} \right)$$

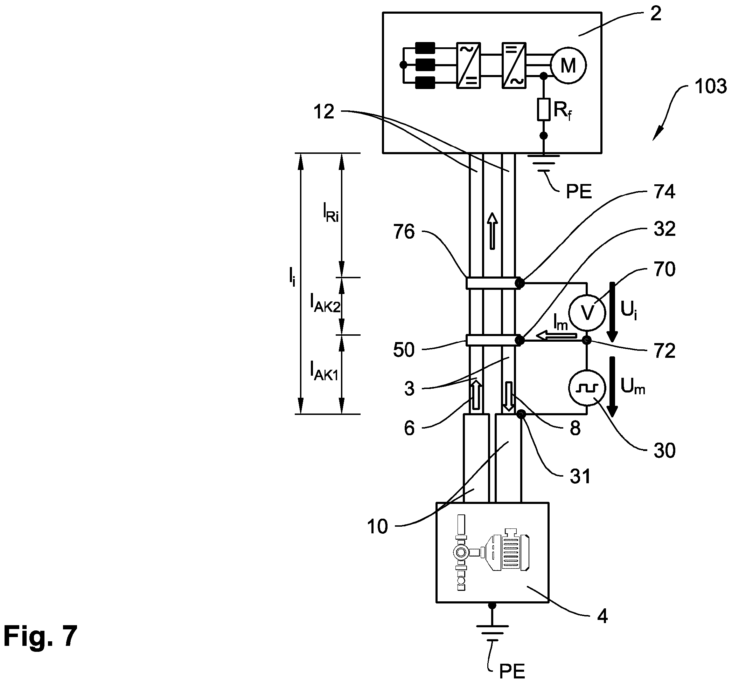

**Fig. 7** zeigt eine erfindungsgemäße Überwachungsvorrichtung 103 mit einer Spannungsmessung.

In dieser Ausführung wird die in den vorgenannten Ausführungen beschriebene Strommessung durch eine Spannungsmessung mit einem Spannungsmesser 70 ersetzt.

Die Einkopplung des Messsignales erfolgt wie in den vorgenannten Ausführungen mit einer niederohmigen Messsignalquelle 30, an die im Abstand einer Ankopplungslänge $l_{AK1}$ - gemessen von dem systemseitigen Ende des elektrisch leitfähigen Rohrleitungabschnitts 10 - ein auf dem elektrisch isolierten Rohrleitungsabschnitt 12 angeordnetes Einkopplungs-Rohrelement 50 angeschlossen ist.

Der Spannungsmesser 70 ist zur Messung einer Teilspannung Ui mit einem ersten Spannungsmesseingang 72 mit dem Einkopplungsanschluss 32 der Messspannungsquelle 30 verbunden und weist einen zweiten Spannungsmesseingang 74 auf, der mit einem leitfähigen das Kühlmittel 3 kontaktierenden Spannungsmess-Rohrelement 76 verbunden ist.

Das Spannungsmess-Rohrelement 76 ist in dem Abstand einer Spannungslänge $l_{AK2}$ in Richtung des elektrischen Systems 2 dem Einkopplungs-Rohrelement 50 nachgeordnet angebracht. Ausgehend von dem Spannungsmess-Rohrelement 76 verbleibt in Richtung des elektrischen Systems 2 eine Widerstandslänge $l_{Ri}$, die zusammen mit der Ankopplungslänge $l_{AK1}$ und der Spannungslänge $l_{AK2}$ die Rohrleitungslänge $l_i$ des elektrisch isolierten Rohrleitungsabschnitts 12 ergibt.

Die Recheneinheit 60 (nicht dargestellt) ermittelt aus den erfassten Größen den Isolationswiderstand $R_f$.

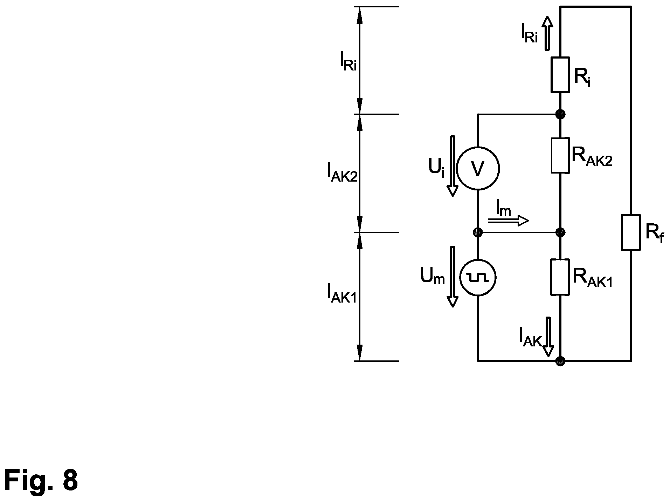

**Fig. 8** zeigt ein aus der Überwachungsvorrichtung 103 nach Fig. 7 abgeleitetes elektrisches Ersatzschaltbild zur Ermittlung des Isolationswiderstands $R_f$.

Das in Fig. 6 für die Überwachungsvorrichtung 100 mit Strommessung geltende Ersatzschaltbild wurde für die Überwachungsvorrichtung 103 mit Spannungsmessung modifiziert. Zu dem Ankoppelwiderstand $R_{AK1}$ tritt in Reihe geschaltet ein Messwiderstand $R_{AK2}$, über den eine auf dem elektrisch isolierten Rohrleitungsabschnitt 12 bestehende Teilspannung Ui erfasst wird.

Da keine Stromerfassung erfolgt, sind der Fehlerstrom $I_{Ri}$ und der Ankoppelstrom $I_{AK}$ zunächst nicht bekannt. In Abänderung der zu Fig. 5 angegebenen Berechnungsformel erfolgt basierend auf dem Ersatzschaltbild nach Fig. 8 die Berechnung des Isolationswiderstands wie folgt

$$Rf = \frac{(U_i + K_2 * U_m) * (K_2 * U_m - U_i * (K_2 + K_i))}{U_i * K_2 * I_m} \text{ mit } K_2 = \frac{l_{AK2}}{l_{AK1}} \text{ und } K_i = \frac{l_{Ri}}{l_{AK1}}$$

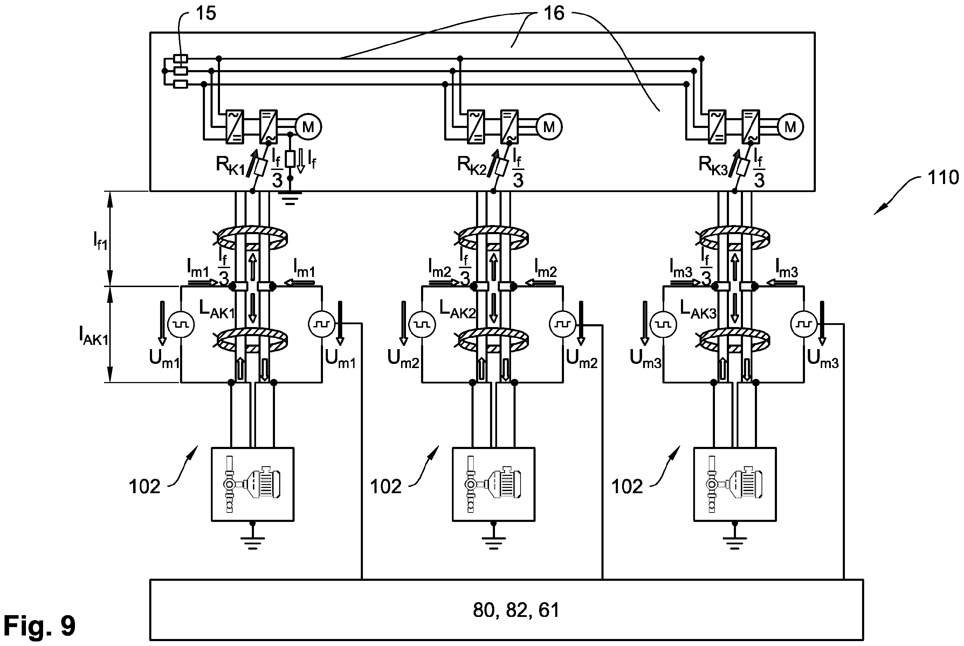

**Fig. 9** zeigt eine erfindungsgemäße erweiterte Überwachungsvorrichtung 110 für drei von einem gemeinsamen Transformator 15 gespeiste ungeerdete elektrische Subsysteme 16.

Jedem der zu überwachenden Subsysteme 16 ist eine erfindungsgemäße Überwachungseinrichtung 102 nach Fig. 5 zugeordnet. Die Überwachungseinrichtung 102 nach Fig. 5 wurde hier beispielhaft gewählt - grundsätzlich kann jedem zu überwachenden Subsystem 16 eine beliebige der beanspruchten Überwachungsvorrichtungen 100, 101, 102, 103 zugeordnet werden.

Die erweiterte Überwachungsvorrichtung 110 weist eine Synchronisations-Steuereinrichtung 80 auf, die eine synchrone Einkopplung der Messsignale in die jeweiligen zu überwachenden elektrischen Subsysteme 16 ermöglicht.

Zusätzlich ist in die Synchronisations-Steuereinrichtung 80 eine Amplituden-Steuereinrichtung 82 integriert, die die Messsignalamplituden der in den jeweiligen Überwachungseinrichtungen 102 erzeugten Messsignale steuert.

Zudem kann die in den einzelnen Überwachungsvorrichtungen 102 angeordnete Recheneinheit durch eine gemeinsame übergeordnete Recheneinheit 61 ersetzt werden.

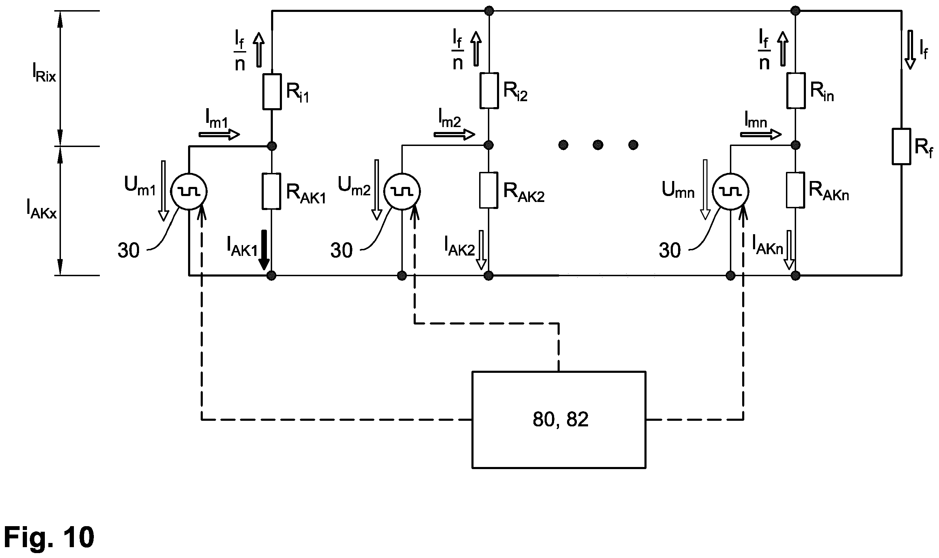

**Fig. 10** zeigt ein elektrisches Ersatzschaltbild zur Bestimmung des Isolationswiderstands Rf mit einer erweiterten Überwachungsvorrichtung 110 nach Fig. 9.

Da sich die erweiterte Überwachungsvorrichtung 110 für eine Anwendung von n (n≥2) elektrischen Subsystemen eignet, ist das Ersatzschaltbild allgemein für n elektrische Subsysteme gültig.

Das Ersatzschaltbild zeigt zusätzlich eine Funktionsgruppe bestehend aus der Synchronisations-Steuereinrichtung 80 und der Amplituden-Steuereinrichtung 82, die mit den jeweiligen Messsignalquellen 30 verbunden sind.

Basierend auf der Gleichung zu dem Ersatzschaltbild in Fig. 5 kann die Berechnung eines Gesamtisolationswiderstandswertes Rf bei einer aus n elektrischen Subsystemen 16 bestehenden Anordnung, die von einem gemeinsamen Transformator 15 gespeist wird, wie folgt aus der Addition der Einzelleitwerte bzw. als Parallelschaltung der berechneten Einzelisolationswiderstandswerte $R_{fi}$ bestimmt werden

$$R_f = \frac{1}{\sum_{i=1}^{n} \frac{1}{R_{fi}}}$$

Die Einzelisolationswiderstandswerte $R_{fi}$ in oben stehender Formel bestimmen sich analog der Gleichung zu Fig. 6 jeweils zu

$$R_{f1} = \frac{U_{m1}}{I_{AK1}} * \left( \frac{I_{AK1}}{I_{Ri1}} - \frac{l_{Ri1}}{l_{AK1}} \right) \quad R_{f2} = \frac{U_{m2}}{I_{AK2}} * \left( \frac{I_{AK2}}{I_{Ri2}} - \frac{l_{Ri2}}{l_{AK2}} \right) \quad R_{fn} = \frac{U_{mn}}{I_{AKn}} * \left( \frac{I_{AKn}}{I_{Rin}} - \frac{l_{Rin}}{l_{AKn}} \right)$$

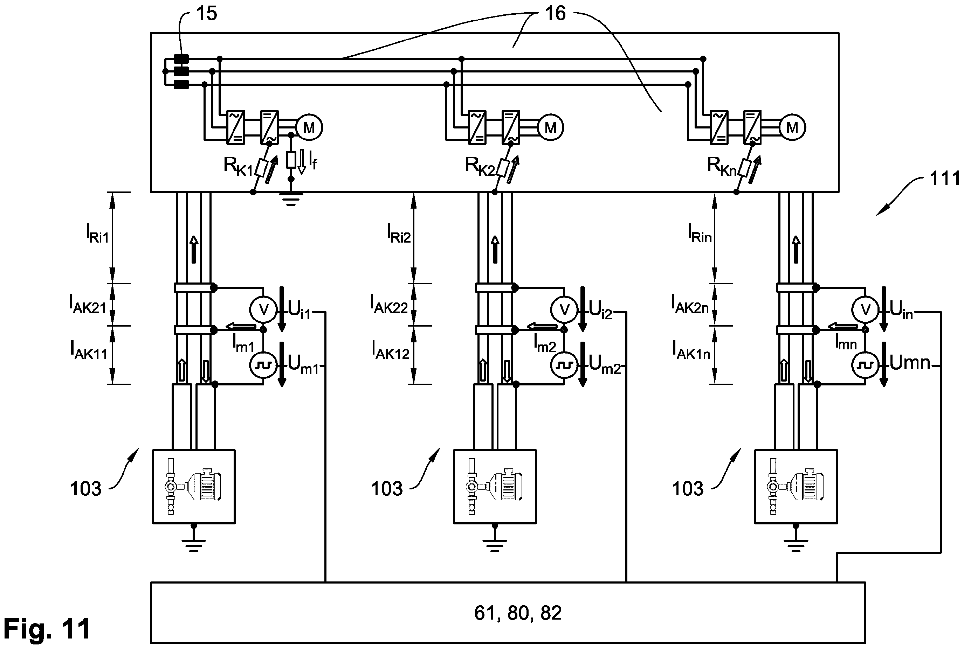

**Fig. 11** zeigt eine erweiterte Überwachungsvorrichtung 111 für drei gemeinsam gespeiste elektrische Subsysteme 16 , wobei jedes dieser Subsysteme mit einer erfindungsgemäßen Überwachungsvorrichtung 103 mit Spannungsmessung nach Fig. 7 ausgestattet ist.

Die erweiterte Überwachungsvorrichtung 111 weist eine Synchronisations-Steuereinrichtung 80, eine gemeinsame Recheneinheit 61 sowie optional eine Amplituden-Steuereinheit 82 auf.

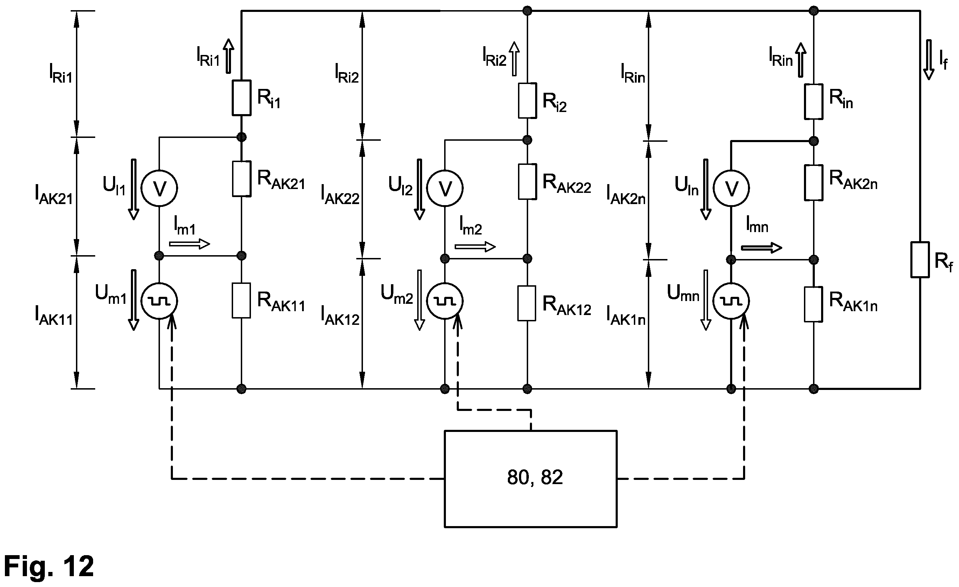

**Fig. 12** zeigt ein elektrisches Ersatzschaltbild für die erweiterte Überwachungsvorrichtung mit Spannungsmessung nach Fig. 11.

Auch in dieser Ausführung müssen die Messspannungsquellen $U_m$ der einzelnen elektrischen Subsysteme 16 synchron zueinander laufen, um zu vermeiden, dass sich die Messsignale gegenseitig stören. So ist es beispielsweise in einem Extremfall denkbar, dass sich der von einer Messsignalquelle 30 eingeprägte Messstrom $I_m$ mit dem von einer anderen Messsignalquelle 30 eingeprägten Messstrom aufhebt. Eine messtechnisch optimale Arbeitsweise wird erwartet, wenn die Messsignalamplituden so eingestellt werden, dass der Strom durch den Isolationswiderstand Rf etwa gleich verteilt auf alle Messzweige fließt. Die Isolationswiderstandsberechnung erfolgt pro Einzelzweig basierend auf den bekannten Längenverhältnissen der Kühlmittelzuführung, den bekannten Messspannungsamplituden $U_m$, dem pro Messzweig gemessenen Werten für Ui und dem jeweils eingespeisten Messstrom $I_m$. Der Gesamtisolationswert wird dann aus der Summe der n Einzelwerte geteilt durch n gebildet.

**Patentansprüche**

1. Überwachungsvorrichtung (100, 101, 102) zur Überwachung eines Isolationswiderstands ($R_f$) für ein ungeerdetes elektrisches System(2), welches eine mit einem Kühlmittel (3) geerdet betriebene Flüssigkeitskühlung mit einer Zuleitung (6) und einer Rückleitung (8) aufweist, wobei die Zuleitung (6) und die Rückleitung (8) jeweils als ein mit Erdpotential (PE) verbundener elektrisch leitfähiger Rohrleitungsabschnitt (10) ausgeführt sind, an den sich ein mit dem elektrischen System (2) verbundener elektrisch isolierter Rohrleitungsabschnitt (12) mit einer Rohrleitungslänge ($l_i$) anschließt, ,
**gekennzeichnet durch**

eine oder zwei niederohmige Messsignalquelle(n) (30), jeweils zur Erzeugung eines Messsignals mit einer Messspannung ($U_m$), mit jeweils einem Erdpotentialanschluss (31), der mit dem elektrisch leitfähigen Rohrleitungsabschnitt (10) verbunden ist, und mit jeweils einem Einkopplungsanschluss (32),
einen Ankoppelstrom-Messsensor (40) zur Messung eines Ankoppelstroms ($I_{AK}$) welcher in dem durch den elektrisch isolierten Rohrleitungsabschnitt (12) strömenden Kühlmittel (3) fließt,
einen dem Ankoppelstrom-Messsensor (40) in Richtung des elektrischen Systems (2) nachgeschalteten Fehlerstrom-Messsensor (42) zur Messung eines Fehlerstroms ($I_{Ri}$), welcher in dem durch den elektrisch isolierten Rohrleitungsabschnitt (12) strömenden Kühlmittel (3) fließt,
ein leitfähiges, das Kühlmittel (3) kontaktierende Einkopplungs-Rohrelement (50), das zur Einkopplung des Messsignals elektrisch mit dem Einkopplungsanschluss (32) der Messsignalquelle (30) verbunden ist, wobei das Einkopplungs-Rohrelement (50) auf dem elektrisch isolierten Rohrleitungsabschnitt (12) zwischen dem Ankoppelstrom-Messsensor (40) und dem Fehlerstrom-Messsensor (42) so angeordnet ist, dass die Rohrleitungslänge ($l_i$) des elektrisch isolierten Rohrleitungsabschnitts (12) in eine sich zwischen dem elektrisch leitfähigen Rohrleitungsabschnitt (10) und dem Einkopplungs-Rohrelement (50) erstreckende Ankopplungslänge ($I_{AK}$) und eine sich von dem Einkopplungs-Rohrelement (50) bis zu dem elektrischen System (2) erstreckende Widerstandslänge ($I_{Ri}$) geteilt ist,
eine Recheneinheit (60), die zur Berechnung des Isolationswiderstands ($R_f$) aus der Messspannung ($U_m$), dem erfassten Ankopplungsstrom ($I_{AK}$), dem erfassten Fehlerstrom ($I_{Ri}$), der Ankopplungslänge ($I_{AK}$) und der Widerstandslänge ($I_{Ri}$) ausgelegt ist.

2. Überwachungsvorrichtung (100, 102) nach Anspruch 1,
**dadurch gekennzeichnet, dass**

der Fehlerstrom-Messsensor (42) einen Fehlerstrom-Messstromwandler aufweist, der gemeinsam die Zuleitung (6) und die Rückleitung (8) umfasst, und
der Ankoppelstrom-Messsensor (40) einen Ankoppelstrom-Messstromwandler aufweist, der gemeinsam die Zuleitung (6) und die Rückleitung (8) umfasst, und
das Einkopplungs-Rohrelement (50) einteilig ausgeführt und mit der Messsignalquelle (30) verbunden ist und das Messsignal gemeinsam in die Zuleitung (6) und die Rückleitung (8) synchron im Gleichtakt einkoppelt oder
das Einkopplungs-Rohrelement (50) zweiteilig in ein Zuleitungs-Einkopplungs-Rohrelement (52) und ein Rückleitungs-Einkopplungs-Rohrelement (54) geteilt ist, die jeweils mit einer der Messsignalquellen (30) verbunden sind und die jeweiligen Messsignale einseitig jeweils in die Zuleitung (6) oder die Rückleitung (8) synchron im Gleichtakt einkoppeln.

3. Überwachungsvorrichtung (101) nach Anspruch 1,
**dadurch gekennzeichnet, dass**

der Fehlerstrom-Messsensor (42) einen Fehlerstrom-Messstromwandler aufweist und
der Ankoppelstrom-Messsensor (40) einen Ankoppelstrom-Messstromwandler aufweist,
wobei der Fehlerstrom-Messstromwandler und der Ankoppelstrom-Messstromwandler beide einseitig die Zuleitung (6) oder beide einseitig die Rückleitung (8) umfassen, und
das Einkopplungs-Rohrelement (50) einteilig ausgeführt und mit der Messsignalquelle (30) verbunden ist und das Messsignal gemeinsam in die Zuleitung (6) und die Rückleitung (8) synchron im Gleichtakt einkoppelt oder

das Einkopplungs-Rohrelement (50) zweiteilig in ein Zuleitungs-Einkopplungs-Rohrelement (52) und ein Rückleitungs-Einkopplungs-Rohrelement (54) geteilt ist, die jeweils mit einer der Messsignalquellen (30) verbunden sind und die jeweiligen Messsignale einseitig jeweils in die Zuleitung (6) oder die Rückleitung (8) synchron im Gleichtakt einkoppeln.

4. Überwachungsvorrichtung nach einem der Ansprüche 1 bis 3,
**gekennzeichnet durch**
eine Verwendung zur Überwachung des Isolationswiderstands ($R_f$) für ein ungeerdetes Stromrichtersystem.

5. Überwachungsvorrichtung (103) zur Überwachung eines Isolationswiderstands ($R_f$) für ein ungeerdetes elektrisches System(2), welches eine mit einem Kühlmittel (3) geerdet betriebene Flüssigkeitskühlung mit einer Zuleitung (6) und einer Rückleitung (8) aufweist, wobei die Zuleitung (6) und die Rückleitung (8) jeweils als ein mit Erdpotential (PE) verbundener elektrisch leitfähiger Rohrleitungsabschnitt (10) ausgeführt sind, an den sich ein mit dem elektrischen System (2) verbundener elektrisch isolierter Rohrleitungsabschnitt (12) mit einer Rohrleitungslänge ($l_i$) anschließt, ,
**gekennzeichnet durch**

eine niederohmige Messsignalquelle (30) zur Erzeugung eines Messsignals mit einer Messspannung ($U_m$), mit einem Erdpotentialanschluss (31), der mit dem elektrisch leitfähigen Rohrleitungsabschnitt (10) verbunden ist, und mit einem Einkopplungsanschluss (32), einen Spannungsmesser (70) zur Messung einer Teilspannung ($U_i$), mit einem ersten Spannungsmess-Eingang (72), der mit dem Einkopplungsanschluss (32) der Messsignalquelle (30) verbunden ist, und mit einem zweiten Spannungsmess-Eingang (74), ein leitfähiges, das Kühlmittel (3) kontaktierende Einkopplungs-Rohrelement(50), das elektrisch mit dem Einkopplungsanschluss (32) der Messsignalquelle (30) verbunden ist zur synchronen Einkopplung des Messsignals im Gleichtakt in die Zuleitung (6) und die Rückleitung (8), ein leitfähiges, das Kühlmittel (3) kontaktierende Spannungsmess-Rohrelement (76), das mit dem zweiten Spannungsmess-Eingang (74) des Spannungsmessers (70) verbunden ist, wobei das Einkopplungs-Rohrelement (50) auf dem elektrisch isolierten Rohrleitungsabschnitt (12) so angeordnet ist, dass sich zwischen dem systemseitigen Ende des elektrisch leitfähigen Rohrleitungsabschnitts (10) und dem Einkopplungs-Rohrelement (50) eine Ankopplungslänge ($l_{AK1}$) ergibt, und das Spannungsmess-Rohrelement (76) daran anschließend auf dem elektrisch isolierten Rohrleitungsabschnitt (12) so angeordnet ist, dass sich zwischen dem Einkopplungs-Rohrelement (50) und dem Spannungsmess-Rohrelement (76) eine Spannungsmesslänge ($l_{AK2}$) ergibt und sich zwischen dem Spannungsmess-Rohrelement und dem elektrischen System eine Widerstandslänge ($l_{Ri}$) ergibt, eine Recheneinheit, die zur Berechnung des Isolationswiderstands aus der Messspannung ($U_m$) des Messsignals, eines eingespeisten Messstroms ($I_m$), der Teilspannung ($U_i$), der Ankopplungslänge ($l_{AK1}$), der Spannungsmesslänge ($l_{AK2}$) und der Widerstandslänge ($l_{Ri}$) ausgelegt ist.

6. Überwachungsvorrichtung nach Anspruch 5,
**gekennzeichnet durch**
eine Verwendung zur Überwachung des Isolationswiderstands ($R_f$) für ein ungeerdetes Stromrichtersystem.

7. Erweiterte Überwachungsvorrichtung (110) zur Überwachung eines gemeinsamen Isolationswiderstands ($R_f$) mehrerer von einem gemeinsamen Transformator (15) gespeister, ungeerdeter elektrischer Subsysteme (16), die jeweils eine mit einem Kühlmittel (3) geerdet betriebene Flüssigkeitskühlung mit einer Zuleitung (6) und einer Rückleitung (8) aufweisen, wobei die Zuleitung (6) und die Rückleitung (8) jeweils als ein mit Erdpotential (PE) verbundener elektrisch leitfähiger Rohrleitungsabschnitt (10) ausgeführt sind, an den sich ein mit dem jeweiligen elektrischen Subsystem (16) verbundener elektrisch isolierter Rohrleitungsabschnitt (12) mit einer Rohrleitungslänge ($l_i$) anschließt,
**dadurch gekennzeichnet, dass**

mindestens zwei der elektrischen Subsysteme (16) mit einer Überwachungsvorrichtung (100, 101, 102, 103) nach einem der Ansprüche 1 bis 6 ausgestattet sind und eine Synchronisations-Steuereinrichtung (80) zur synchronen Einkopplung der Messsignale in die zu überwachenden elektrischen Subsysteme (16) installiert ist.

8. Erweiterte Überwachungsvorrichtung (110) nach Anspruch 7,
**dadurch gekennzeichnet, dass**

die Synchronisations-Steuereinrichtung (80) eine Amplituden-Steuereinrichtung (82) aufweist zur Steuerung der Messsignalamplituden der in den jeweiligen Überwachungsvorrichtungen (100, 101, 102, 103) erzeugten Messsignale.

9. Verfahren zur Überwachung eines Isolationswiderstands ($R_f$) für ein ungeerdetes elektrisches System (2), welches eine mit einem Kühlmittel (3) geerdet betriebene Flüssigkeitskühlung mit einer Zuleitung (6) und einer Rückleitung (8) aufweist, wobei die Zuleitung (6) und die Rückleitung (8) jeweils als ein mit Erdpotential (PE) verbundener elektrisch leitfähiger Rohrleitungsabschnitt (10) ausgeführt sind, an den sich ein mit dem elektrischen System (2) verbundener elektrisch isolierter Rohrleitungsabschnitt (12) mit einer Rohrleitungslänge ($l_i$) anschließt, umfassend die Verfahrensschritte:

Erzeugen eines Messsignals mit einer Messspannung ($U_m$) mittels einer niederohmigen Messsignalquelle (30), Synchrones Einkoppeln der Messspannung ($U_m$) im Gleichtakt in die Zuleitung (6) und die Rückleitung (8) mit einem leitfähigen, das Kühlmittel (3) kontaktierenden Einkopplungs-Rohrelement (50),

Messen eines Ankoppelstroms ($I_{AK}$), welcher in dem durch den elektrisch isolierten Rohrleitungsabschnitt (12) strömenden Kühlmittel (3) fließt mit einem Ankoppelstrom-Messsensor (40),

Messen eines Fehlerstroms ($I_{Ri}$), welcher in dem durch den elektrisch isolierten Rohrleitungsabschnitt (12) strömenden Kühlmittel (3) fließt mit einem dem Ankoppelstrom-Messsensor (40) in Richtung des elektrischen Systems (2) nachgeschalteten Fehlerstrom-Messsensor (42),

wobei das Einkopplungs-Rohrelement (50) auf dem elektrisch isolierten Rohrleitungsabschnitt (12) zwischen dem Ankoppelstrom-Messsensor (40) und dem Fehlerstrom-Messsensor (42) so angeordnet wird, dass die Rohrleitungslänge ($l_i$) des elektrisch isolierten Rohrleitungsabschnitts (12) in eine sich zwischen dem elektrisch leitfähigen Rohrleitungsabschnitt (10) und dem Einkopplungs-Rohrelement (50) erstreckende Ankopplungslänge ($l_{AK}$) und eine sich von dem Einkopplungs-Rohrelement (50) bis zu dem elektrischen System (2) erstreckende Widerstandslänge ($l_{Ri}$) geteilt wird,

Berechnen des Isolationswiderstands ($R_f$) aus der Messspannung ($U_m$) des Messsignals, dem erfassten Ankopplungsstrom ($I_{AK}$), dem erfassten Fehlerstrom ($I_{Ri}$), der Ankopplungslänge ($l_{AK}$) und der Widerstandslänge ($l_{Ri}$) mit einer Recheneinheit (60).

10. Überwachungsverfahren nach Anspruch 9,
**gekennzeichnet durch**
eine Anwendung zur Überwachung des Isolationswiderstands ($R_f$) für ein ungeerdetes Stromrichtersystem.

11. Verfahren zur Überwachung eines Isolationswiderstands ($R_f$) für ein ungeerdetes elektrisches System (2), welches eine mit einem Kühlmittel (3) geerdet betriebene Flüssigkeitskühlung mit einer Zuleitung (6) und einer Rückleitung (8) aufweist, wobei die Zuleitung (6) und die Rückleitung (8) jeweils als ein mit Erdpotential (PE) verbundener elektrisch leitfähiger Rohrleitungsabschnitt (10) ausgeführt sind, an den sich ein mit dem elektrischen System (2) verbundener elektrisch isolierter Rohrleitungsabschnitt (12) mit einer Rohrleitungslänge ($l_i$) anschließt, umfassend die Verfahrensschritte:

Erzeugen einer Messsignals mit einer Messspannung ($U_m$) durch eine Messsignalquelle (30), die einen Erdpotentialanschluss (31), der mit dem elektrisch leitfähigen Rohrleitungsabschnitt (10) verbunden ist und einen Einkopplungsanschluss (32) aufweist,

Synchrones Einkoppeln der Messspannung ($U_m$) im Gleichtakt in die Zuleitung (6) und die Rückleitung (8) mit einem leitfähigen, das Kühlmittel (3) kontaktierenden Einkopplungs-Rohrelement (50), das elektrisch mit dem Einkopplungsanschluss (32) der Messsignalquelle (30) verbunden ist,

Messen einer Teilspannung ($U_i$) mit einen Spannungsmesser (70), der einen ersten Spannungsmess-Eingang (72), der mit dem Einkopplungsanschluss (32) der Messsignalquelle (30) verbunden ist, und einen zweiten Spannungsmess-Eingang (74), der mit einem leitfähigen, das Kühlmittel (3) kontaktierenden Spannungsmess-Rohrelement (76) verbunden ist, aufweist,

wobei das Einkopplungs-Rohrelement (50) auf dem elektrisch isolierten Rohrleitungsabschnitt (12) so angeordnet wird, dass sich zwischen dem elektrisch leitfähigen Rohrleitungsabschnitt (10) und dem Einkopplungs-Rohrelement (50) eine Ankopplungslänge ($l_{AK1}$) ergibt, und das Spannungsmess-Rohrelement (76) daran anschließend auf dem elektrisch isolierten Rohrleitungsabschnitt (12) so angeordnet wird, dass sich zwischen dem Einkopplungs-Rohrelement (50) und dem Spannungsmess-Rohrelement (76) eine Spannungsmesslänge ($l_{AK2}$) ergibt und sich zwischen dem Spannungsmess-Rohrelement (76) und dem elektrischen System (2) eine Widerstandslänge ($l_{Ri}$) ergibt,

Berechnen des Isolationswiderstands ($R_f$) aus der Messspannung ($U_m$) des Messsignals, eines eingespeisten

Messstroms ($I_m$), der Teilspannung ($U_i$), der Ankopplungslänge ($I_{AK1}$), der Spannungsmesslänge ($I_{AK2}$) und der Widerstandslänge ($I_{Ri}$).

**12.** Überwachungsverfahren nach Anspruch 11,
**gekennzeichnet durch**
eine Anwendung zur Überwachung des Isolationswiderstands ($R_f$) für ein ungeerdetes Stromrichtersystem.

**13.** Erweitertes Verfahren zur Überwachung eines gemeinsamen Isolationswiderstands mehrerer von einem gemeinsamen Transformator (15) gespeister, ungeerdeter elektrischer Subsysteme (16), die jeweils eine mit einem Kühlmittel (3) geerdet betriebene Flüssigkeitskühlung mit einer Zuleitung (3) und einer Rückleitung (8) aufweisen, wobei die Zuleitung (3) und die Rückleitung (8) jeweils als ein mit Erdpotential (PE) verbundener elektrisch leitfähiger Rohrleitungsabschnitt (10) ausgeführt sind, an den sich ein mit dem jeweiligen elektrischen Subsystem (16) verbundener elektrisch isolierter Rohrleitungsabschnitt (12) mit einer Rohrleitungslänge ($I_i$) anschließt,
**dadurch gekennzeichnet,**

**dass** mindestens zwei der ungeerdeten elektrischen Subsysteme (16) mit einem Verfahren zur Überwachung eines Isolationswiderstands nach einem der Ansprüche 9 bis 12 überwacht werden und
eine synchrone Einkopplung der Messsignale in die zu überwachenden elektrischen Subsysteme (16) mittels einer Synchronisations-Steuereinrichtung (80) erfolgt.

**14.** Erweitertes Überwachungsverfahren nach Anspruch 13,
**dadurch gekennzeichnet,**
**dass** eine Steuerung der Messsignalamplituden der Messsignale mittels einer Amplituden-Steuereinrichtung (82) erfolgt.

**Claims**

**1.** A monitoring device (100, 101, 102) for monitoring an insulation resistance ($R_f$) for an ungrounded electric system (2) which comprises a liquid cooling which is operated to ground using a refrigerant (3) and has a supply line (6) and a return line (8), the supply line (6) and the return line (8) each being realized as a tube section (10) which is connected to a ground potential (PE) and is electrically conductive and to which an electrically insulated tube section (12) is connected which has a tube length ($I_i$) and is connected to the electric system (2),
**characterized by**

one or two low-impedance measuring signal sources (30) each configured for generating a measuring signal having a measuring voltage ($U_m$), each comprising a ground-potential connection (31) connected to the electrically conductive tube section (10), and each comprising a coupling connection (32),
a coupling-current measuring sensor (40) for measuring a coupling current ($I_{AK}$) which flows in the refrigerant (3) flowing through the electrically insulated tube section (12),
a fault-current measuring sensor (42) which is switched downstream of the coupling-current measuring sensor (40) in the direction of the electric system (2) and is configured for measuring a fault current ($I_{Ri}$) which flows in the refrigerant (3) flowing through the electrically insulated tube section (12),
a conductive coupling tube element (50) which contacts the refrigerant (3) and is electrically connected to the coupling connection (32) of the measuring signal source (30) for coupling the measuring signal, the coupling tube element (50) being disposed in such a manner on the electrically insulated tube section (12) between the coupling-current measuring sensor (40) and the fault-current measuring sensor (42) that the tube length ($I_i$) of the electrically insulated tube section (12) is divided into a coupling length ($I_{AK}$) extending between the electrically conductive tube section (10) and the coupling tube element (50) and a resistance length ($I_{Ri}$) extending from the coupling tube element (50) to the electric system (2),
a computing unit (60) which is configured for computing the insulation resistance (Rf) from the measuring voltage ($U_m$), the detected coupling current ($I_{AK}$), the detected fault current ($I_{Ri}$), the coupling length ($I_{AK}$) and the resistance length ($I_{Ri}$).

**2.** The monitoring device (100, 102) according to claim 1, **characterized in that**

the fault-current measuring sensor (42) comprises a fault-current measuring current transformer which encircles both the supply line (6) and the return line (8), and

the coupling-current measuring sensor (40) comprises a coupling-current measuring current transformer which encircles both the supply line (6) and the return line (8), and

the coupling tube element (50) is realized in one part and is connected to the measuring signal source (30) and the measuring signal is synchronously coupled both into the supply line (6) and the return line (8) in common mode, or

the coupling tube element (50) is divided into two parts in a supply-line coupling tube element (52) and a return-line coupling tube element (54) which are each connected to one of the measuring signal sources (30) and synchronously couple the corresponding measuring signals into the supply line (6) or the return line (8) on one side in common mode.

3. The monitoring device (101) according to claim 1,
**characterized in that**

the fault-current measuring sensor (42) comprises a fault-current measuring current transformer and

the coupling-current measuring sensor (40) comprises a coupling-current measuring current transformer,

the fault-current measuring current transformer and the coupling-current measuring current transformer both encircle the supply line (6) on one side and the return line (8) on one side, and

the coupling tube element (50) is realized in one part and is connected to the measuring signal source (30) and the measuring signal is synchronously coupled together into the supply line (6) and the return line (8) in common mode, or

the coupling tube element (50) is divided into two parts in a supply-line coupling tube element (52) and a return-line coupling tube element (54) which are each connected to one of the measuring signal sources (30) and synchronously couple the corresponding measuring signals into the supply line (6) or the return line (8) on one side in common mode.

4. The monitoring device according to any one of the claims 1 to 3, **characterized by**
a use for monitoring the insulation resistance (Rf) for an ungrounded power converter system.

5. A monitoring device (103) for monitoring an insulation resistance (Rf) for an ungrounded electric system (2) which comprises a liquid cooling which is operated to ground using a refrigerant (3) and comprises a supply line (6) and a return line (8), the supply line (6) and the return line (8) each being realized as an electrically conductive tube section (10) which is connected to a ground potential (PE) and to which an electrically insulated tube section (12) is connected which has a tube length ($l_i$) and is connected to the electric system (2),
**characterized by**

a low-impedance measuring signal source (30) configured for generating a measuring signal having a measuring voltage ($U_m$), the measuring signal source (30) comprising a ground-potential connection (31) connected to the electrically conductive tube section (10) and comprising a coupling connection (32),

a voltage meter (70) for measuring a partial voltage ($U_i$), the voltage meter (70) comprising a first voltage-meter input (72) connected to the coupling connection (32) of the measuring signal source (30), and the voltage meter comprising a second voltage-meter input (74),

a conductive coupling tube element (50) which contacts the refrigerant (3) and is electrically connected to the coupling connection (32) of the measuring signal source (30) for synchronously coupling the measuring signal into the supply line (6) and the return line (8) in common mode,

a conductive voltage-meter tube element (76) which contacts the refrigerant (3) and is connected to the second voltage-meter input (74) of the voltage meter (70),

the coupling tube element (50) being disposed in such a manner on the electrically insulated tube section (12) that a coupling length ($l_{AK1}$) is yielded between the system-sided end of the electrically conductive tube section (10) and the coupling tube element (50), and the voltage-meter tube element (76) being disposed in such a manner adjacent to the electrically insulated tube section (12) that a voltage-meter length ($l_{AK2}$) is yielded between the coupling tube element (50) and the voltage-meter tube element (76) and a resistance length ($l_{Ri}$) is yielded between the voltage-meter tube element and the electric system,

a computing unit which is configured for computing the insulation resistance from the measuring voltage ($U_m$) of the measuring signal, a supplied measuring current ($I_m$), the partial voltage ($U_i$), the coupling length ($l_{AK1}$), the voltage-meter length ($l_{AK2}$) and the resistance length ($l_{Ri}$).

6. The monitoring device according to claim 5,
**characterized by**

a use for monitoring the insulation resistance (Rf) for an ungrounded power converter system.

7. An enhanced monitoring device (110) for monitoring a shared insulation resistance ($R_f$) of several ungrounded electric subsystems (16) which are fed by a shared transformer (15) and each comprise a liquid cooling operated to ground using a refrigerant (3) and comprising a supply line (6) and a return line (8), the supply line (6) and the return line (8) each being realized as an electrically conductive tube section (10) which is connected to a ground potential (PE) and to which an electrically insulated tube section (12) is connected which has a tube length ($l_i$) is and connected to the corresponding electric subsystem (16),
**characterized in that**

at least two of the electric subsystems (16) are equipped with a monitoring device (100, 101, 102, 103) according to any one of the claims 1 to 6, and
a synchronization control device (80) for synchronously coupling the measuring signals into the electric subsystems (16) to be monitored is installed.

8. The enhanced monitoring device (110) according to claim 7, **characterized in that**
the synchronization control device (80) comprises an amplitude control device (82) for controlling the measuring-signal amplitudes of the measuring signals generated in the corresponding monitoring devices (100, 101, 102, 103).

9. A method for monitoring an insulation resistance (Rf) for an ungrounded electrical system (2) which comprises a liquid cooling which is operated to ground using a refrigerant (3) and comprises a supply line (6) and a return line (8), the supply line (6) and the return line (8) each being realized as an electrically conductive tube section (10) which is connected to a ground potential (PE) and to which an electrically insulated tube section (12) is connected which is connected to the electric system (2) and has a tube length ($l_i$), the method comprising the steps:

generating a measuring signal having a measuring voltage ($U_m$) using a low-impedance measuring signal source (30),
synchronously coupling the measuring voltage ($U_m$) in common mode into the supply line (6) and the return line (8) having a conductive coupling tube element (50) contacted with the refrigerant (3),
measuring a coupling current ($I_{AK}$) which flows in the refrigerant (3), which flows through the electrically insulated tube section (12), using a coupling-current measuring sensor (40), measuring a fault current ($I_{Ri}$) which flows in the refrigerant (3), which flows through the electrically insulated tube section (12), using a fault-current measuring sensor (42) switched downstream of the coupling-current measuring sensor (40) in the direction of the electric system (2),
the coupling tube element (50) being disposed in such a manner on the electrically insulated tube section (12) between the coupling-current measuring sensor (40) and the fault-current measuring sensor (42) that the tube length ($l_i$) of the electrically insulated tube section (12) is divided into a coupling length ($l_{AK}$) extending between the electrically conductive tube section (10) and the coupling tube element (50) and a resistance length ($l_{Ri}$) extending from the coupling tube element (50) to the electric system (2), computing the insulation resistance (Rf) from the measuring voltage ($U_m$) of the measuring signal, the detected coupling current ($I_{AK}$), the detected fault current ($I_{Ri}$), the coupling length ($l_{AK}$) and the resistance length ($l_{Ri}$) using a computing unit (60).

10. The monitoring method according to claim 9,
**characterized by**
a use for monitoring the insulation resistance (Rf) for an ungrounded power converter system.

11. A method for monitoring an insulation resistance (Rf) for an ungrounded electric system (2) which comprises a liquid cooling which is operated to ground using a refrigerant (3) and comprises a supply line (6) and a return line (8), the supply line (6) and the return line (8) each being realized as an electrically conductive tube section (10) which is connected to a ground potential (PE) and to which an electrically insulated tube section (12) is connected which is connected to the electric system (2) and has a tube length ($l_i$), the method comprising the steps:

generating a measuring signal having a measuring voltage ($U_m$) via a measuring signal source (30) which comprises a ground-potential connection (31), which is connected to the electrically conductive tube section (10), and a coupling connection (32),
synchronously coupling the measuring voltage ($U_m$) in common mode into the supply line (6) and the return line (8) having a conductive coupling tube element (50) which is contacted with the refrigerant (3) and is electrically connected to the coupling connection (32) of the measuring signal source (30),

measuring a partial voltage (Ui) using a voltage meter (70) which comprises a first voltage-meter input (72) connected to the coupling connection (32) of the measuring signal source (30) and a second voltage-meter input (74) connected to a conductive voltage-meter tube element (76) contacted with the refrigerant (3),

the coupling tube element (50) being disposed in such a manner on the electrically insulated tube section (12) that a coupling length ($l_{AK1}$) is yielded between the electrically conductive tube section (10) and the coupling tube element (50), and the voltage-meter tube element (76) is adjacently disposed in such a manner on the electrically insulated tube section (12) that a voltage-meter length ($l_{AK2}$) is yielded between the coupling tube element (50) and the voltage-meter tube element (76) and a resistance length ($l_{Ri}$) is yielded between the voltage-meter tube element (76) and the electric system (2),

computing the insulation resistance (Rf) from the measuring voltage ($U_m$) of the measuring signal, a supplied measuring current ($I_m$), the partial voltage ($U_i$), the coupling length ($l_{AK1}$), the voltage-meter length ($l_{AK2}$) and the resistance length ($l_{Ri}$).

**12.** The monitoring method according to claim 11,
   **characterized by**
   a use for monitoring the insulation resistance (Rf) for an ungrounded power converter system.

**13.** An enhanced method for monitoring a shared insulation resistance of several ungrounded electric subsystems (16) which are fed by a shared transformer (15) and each comprise a liquid cooling which is operated to ground using a refrigerant (3) and comprises a supply line (6) and a return line (8), the supply line (6) and the return line (8) each being realized as an electrically conductive tube section (10) which is connected to a ground potential (PE) and to which an electrically insulated tube section (12) is connected which is connected to the corresponding electric subsystem (16) and has a tube length ($l_i$),
   **characterized in that**
   at least two of the ungrounded electric subsystems (16) are monitored using a method for monitoring an insulation resistance according to any one of the claims 9 to 12 and the measuring signals are synchronously coupled into the electric subsystems (16) to be monitored by means of a synchronization control device (18).

**14.** The enhanced monitoring method according to claim 13, **characterized in that**
   the measuring-signal amplitudes of the measuring signals are controlled by means of an amplitude control device (82).

**Revendications**

**1.** Dispositif de surveillance (100, 101, 102) pour surveiller une résistance d'isolation (Rf) pour un système électrique (2) non mis à la terre qui comprend un refroidissement des liquides qui est opéré à la terre en utilisant un fluide de refroidissement (3) et a une conduite d'alimentation (6) et une conduite de retour (8), la conduite d'alimentation (6) et la conduite de retour (8) étant réalisées chacune sous la forme d'une section de tuyau (10) qui est conductrice électriquement et connectée à un potentiel de terre (PE) et à laquelle est connectée une section de tuyau (12) isolée électriquement, connectée au système électrique (2) et ayant une longueur de tuyau ($l_i$),
   **caractérisé par**

   une ou deux sources (30) de signal de mesure à basse impédance, chacune étant conçue pour générer un signal de mesure ayant une tension de mesure ($U_m$), chacune comprenant une connexion (31) de potentiel de terre connectée à la section de tuyau (10) conductrice électriquement, et chacune comprenant un branchement de couplage (32),
   un capteur (40) de mesure de courant de couplage pour mesurer un courant de couplage ($I_{AK}$) qui s'écoule dans le fluide de refroidissement (3) s'écoulant à travers la section de tuyau isolée électriquement (12),
   un capteur (42) de mesure de courant de défaut qui est commuté en aval du capteur (40) de mesure de courant de couplage dans la direction du système électrique (2) et qui est configuré pour mesurer un courant de défaut ($I_{Ri}$) qui s'écoule dans le fluide de refroidissement (3) s'écoulant à travers la section de tuyau (12) isolée électriquement,
   un élément (50) conducteur de tuyau de couplage qui est en contact avec le fluide de refroidissement (3) et est connecté électriquement au branchement de couplage (32) de la source (30) de signal de mesure pour coupler le signal de mesure, l'élément (50) de tuyau de couplage étant disposé sur la section de tuyau (12) isolée électriquement entre le capteur (40) de mesure de courant de couplage et le capteur (42) de mesure de courant de défaut de telle manière que la longueur de tuyau ($l_i$) de la section de tuyau (12) isolée électriquement est divisée en une longueur de couplage ($l_{AK}$) s'étendant entre la section de tuyau (10) conductrice électriquement et l'élément (50) de tuyau de couplage et une longueur de résistance ($l_{Ri}$) s'étendant de l'élément (50) de tuyau de couplage au système électrique (2),

une unité de calcul (60) qui est configurée pour calculer la résistance d'isolation ($R_f$) de la tension de mesure ($U_m$), du courant de couplage ($I_{AK}$) détecté, du courant de défaut ($I_{Ri}$) détecté, de la longueur de couplage ($l_{AK}$) et de la longueur de résistance ($l_{Ri}$)

2. Dispositif de surveillance (100, 102) selon la revendication 1, **caractérisé en ce que**

le capteur (42) de mesure de courant de défaut comprend un transformateur de courant de mesure de courant de défaut qui encercle à la fois le conduit d'alimentation (6) et le conduit de retour (8), et le capteur (40) de mesure de courant de couplage comprend un transformateur de courant de mesure de courant de couplage qui encercle à la fois la conduite d'alimentation (6) et la conduite de retour (8), et

l'élément (50) de tuyau de couplage est réalisé en une seule partie et est connecté à la source (30) de signal de mesure et le signal de mesure est couplé de manière synchrone à la fois dans la conduite d'alimentation (6) et la conduite de retour (8) en mode commun, ou l'élément (50) de tuyau de couplage est divisé en deux parties en un élément (52) de tuyau de couplage de la conduite d'alimentation et un élément (54) de tuyau de couplage de la conduite de retour qui sont chacun connectés à l'une des sources (30) de signal de mesure et couplent de manière synchrone les signaux de mesure correspondants dans la conduite d'alimentation (6) ou la conduite de retour (8) d'un côté en mode commun.

3. Dispositif de surveillance (101) selon la revendication 1, **caractérisé en ce que**

le capteur (42) de mesure de courant de défaut comprend un transformateur de courant de mesure de courant de défaut et

le capteur (40) de mesure de courant de couplage comprend un transformateur de courant de mesure de courant de couplage,

le transformateur de courant de mesure de courant de défaut et le transformateur de courant de mesure de courant de couplage encerclant tous deux la conduite d'alimentation (6) sur un côté ou tous deux la conduite de retour (8) sur un côté, et

l'élément (50) de tuyau de couplage étant réalisé en une seule partie et étant connecté à la source (30) de signal de mesure et le signal de mesure étant couplé de manière synchrone dans la conduite d'alimentation (6) et la conduite de retour (8) en mode commun, ou l'élément (50) de tuyau de couplage étant divisé en deux parties en un élément (52) de tuyau de couplage de la conduite d'alimentation et un élément (54) de tuyau de couplage de la conduite de retour qui sont chacun connectés à l'une des sources (30) de signal de mesure et couplent de manière synchrone les signaux de mesure correspondants dans la conduite d'alimentation (6) ou la conduite de retour (8) d'un côté en mode commun.

4. Dispositif de surveillance selon l'une quelconque des revendications 1 à 3, **caractérisé par**
une utilisation pour surveiller la résistance d'isolement (Rf) d'un système de convertisseur de puissance non mis à la terre.

5. Dispositif de surveillance (103) pour surveiller une résistance d'isolation (Rf) pour un système électrique (2) non mis à la terre qui comprend un refroidissement des liquides qui est opéré à la terre en utilisant un fluide de refroidissement (3) et a une conduite d'alimentation (6) et une conduite de retour (8), la conduite d'alimentation (6) et la conduite de retour (8) étant réalisées chacune sous la forme d'une section de tuyau (10) qui est conductrice électriquement et connectée à un potentiel de terre (PE) et à laquelle est connectée une section de tuyau (12) isolée électriquement, connectée au système électrique (2) et ayant une longueur de tuyau ($l_i$),
**caractérisé par**

une source (30) de signal de mesure à basse impédance conçue pour générer un signal de mesure ayant une tension de mesure ($U_m$), comprenant une connexion (31) de potentiel de terre connectée à la section de tuyau (10) conductrice électriquement, et comprenant un branchement de couplage (32),

un voltmètre (70) pour mesurer une tension partielle ($U_i$), le voltmètre (70) comprenant une première entrée de voltmètre (72) connectée au branchement de couplage (32) de la source (30) de signal de mesure, et le voltmètre comprenant une deuxième entrée de voltmètre (74),

un élément conducteur (50) de tuyau de couplage qui est en contact avec le fluide de refroidissement (3) et est connecté électriquement au branchement de couplage (32) de la source (30) de signal de mesure pour coupler de manière synchrone le signal de mesure dans la conduite d'alimentation (6) et la conduite de retour (8) en mode commun,

un élément conducteur (76) de tuyau de voltmètre qui est en contact avec le fluide de refroidissement (3) et est connecté à la deuxième entrée de voltmètre (74) du voltmètre (70),

l'élément (50) de tuyau de couplage étant disposé sur la section (12) de tuyau isolée électriquement de telle manière qu'une longueur de couplage ($l_{AK1}$) est obtenue entre l'extrémité côté système de la section de tuyau (10) conductrice électriquement et l'élément (50) de tuyau de couplage, et l'élément (76) de tuyau de voltmètre étant disposé de manière adjacente à la section de tuyau (12) isolée électriquement de telle manière qu'une longueur ($l_{AK2}$) de mesure de tension est obtenue entre l'élément (50) de tuyau de couplage et l'élément (76) de tuyau de voltmètre et une longueur de résistance ($l_{Ri}$) est obtenue entre l'élément de tuyau de voltmètre et le système électrique,

une unité de calcul qui est configurée pour calculer la résistance d'isolement de la tension de mesure ($U_m$) du signal de mesure, d'un courant de mesure ($I_m$) fourni, de la tension partielle ($U_i$), de la longueur de couplage ($l_{AK1}$), de la longueur de mesure de tension ($l_{AK2}$) et de la longueur de résistance ($l_{Ri}$).

6. Dispositif de surveillance selon la revendication 5,
**caractérisé par**
une utilisation pour surveiller la résistance d'isolement (Rf) d'un système de convertisseur de puissance non mis à la terre

7. Dispositif de surveillance (110) accru pour surveiller une résistance d'isolation ($R_f$) commune de plusieurs sous-systèmes électriques (16) non mis à la terre qui sont alimentés par un transformateur (15) commun et comprennent chacun un refroidissement des liquides opéré à la terre en utilisant un fluide de refroidissement (3) et comprenant une conduite d'alimentation (6) et une conduite de retour (8), la conduite d'alimentation (6) et la conduite de retour (8) étant chacune réalisée sous la forme d'une section de tuyau (10) conductrice électriquement qui est connectée à un potentiel de terre (PE) et à laquelle est connectée une section de tuyau (12) isolée électriquement, connectée au sous-système électrique (16) correspondant et ayant une longueur de tuyau ($l_i$), **caractérisé en ce**

**qu'**au moins deux des sous-systèmes électriques (16) sont équipés d'un dispositif de surveillance (100, 101, 102, 103) selon l'une quelconque des revendications 1 à 6, et
un dispositif (80) de commande de synchronisation pour coupler de manière synchrone les signaux de mesure dans les sous-systèmes électriques (16) à surveiller est installé.

8. Dispositif de surveillance (110) accru selon la revendication 7, **caractérisé en ce que**
le dispositif (80) de commande de synchronisation comprend un dispositif (82) de commande d'amplitude pour commander les amplitudes des signaux de mesure générées dans le dispositif de surveillance (100, 101, 102, 103) correspondants.

9. Procédé de surveillance d'une résistance d'isolement (Rf) pour un système électrique (2) non mis à la terre qui comprend un refroidissement des liquides qui est opéré à la terre en utilisant un fluide de refroidissement (3) et a une conduite d'alimentation (6) et une conduite de retour (8), la conduite d'alimentation (6) et la conduite de retour (8) étant réalisée chacune sous la forme d'une section (10) de tuyau conductrice électriquement qui est connectée à un potentiel de terre (PE) et à laquelle est connectée une section de tuyau (12) isolée électriquement qui est connectée au système électrique (2) et a une longueur de tuyau ($l_i$), le procédé comprenant les étapes consistant à :

générer un signal de mesure ayant une tension de mesure ($U_m$) en utilisant une source (30) de signal de mesure à basse impédance, coupler de manière synchrone la tension de mesure ($U_m$) en mode commun dans la conduite d'alimentation (6) et la conduite de retour (8) ayant un élément conducteur (50) de tuyau de couplage en contact avec le fluide de refroidissement (3),
mesurer un courant de couplage ($I_{AK}$) qui s'écoule dans le fluide de refroidissement (3), qui s'écoule à travers la section (12) de tuyau isolée électriquement, en utilisant un capteur (40) de mesure de courant de couplage,
mesurer un courant de défaut ($I_{Ri}$) qui s'écoule dans le fluide de refroidissement (3), qui s'écoule à travers la section (12) de tuyau isolée électriquement, en utilisant un capteur (42) de mesure de courant de défaut commuté en aval du capteur (40) de mesure de courant de couplage dans la direction du système électrique (2), l'élément (50) de tuyau de couplage étant disposé sur la section de tuyau (12) isolée électriquement entre le capteur (40) de mesure de courant de couplage et le capteur (42) de mesure de courant de défaut de telle manière que la longueur de tuyau ($l_i$) de la section de tuyau (12) isolée électriquement est divisée en une longueur de couplage ($l_{AK}$) s'étendant entre la section de tuyau (10) conductrice électriquement et l'élément (50) de tuyau de couplage et une longueur de résistance ($I_{Ri}$) s'étendant de l'élément (50) de tuyau de couplage au système électrique (2), calculer la résistance d'isolement ($R_f$) de la tension de mesure ($U_m$) du signal de mesure, du courant de couplage ($I_{AK}$) détecté, du courant de défaut ($I_{Ri}$) détecté, de la longueur de couplage ($I_{AK}$) et de la longueur de résistance ($I_{Ri}$) en utilisant une unité de calcul (60).

10. Procédé de surveillance selon la revendication 9,
**caractérisé par**
une utilisation pour surveiller la résistance d'isolement (Rf) d'un système de convertisseur de puissance non mis à la terre.

11. Procédé de surveillance d'une résistance d'isolement (Rf) pour un système électrique (2) non mis à la terre qui comprend un refroidissement des liquides qui est opéré à la terre en utilisant un fluide de refroidissement (3) et a une conduite d'alimentation (6) et une conduite de retour (8), la conduite d'alimentation (6) et la conduite de retour (8) étant chacune réalisée sous la forme d'une section (10) de tuyau conductrice électriquement qui est connectée à un potentiel de terre (PE) et à laquelle est connectée une section de tuyau (12) isolée électriquement qui est connectée au système électrique (2) et a une longueur de tuyau ($I_i$), le procédé comprenant les étapes consistant à :

générer un signal de mesure ayant une tension de mesure ($U_m$) par une source (30) de signal de mesure qui comprend une connexion (31) de potentiel de terre, qui est connectée à la section (10) de tuyau conductrice électriquement, et un branchement de couplage (32),
coupler de manière synchrone la tension de mesure ($U_m$) en mode commun dans la conduite d'alimentation (6) et la conduite de retour (8) ayant un élément conducteur (50) de tuyau de couplage qui est en contact avec le fluide de refroidissement (3) et est connecté électriquement à un branchement de couplage (32) de la source (30) de signal de mesure,
mesurer une tension partielle (Ui) en utilisant un voltmètre (70) qui comprend une première entrée de voltmètre (72) connectée au branchement de couplage (32) de la source (30) de signal de mesure et une deuxième entrée de voltmètre (74) connectée à un élément (76) de tuyau de voltmètre conducteur en contact avec le fluide de refroidissement (3),
l'élément (50) de tuyau de couplage étant disposé sur la section de tuyau (12) isolée électriquement de telle manière qu'une longueur de couplage ($I_{AK1}$) est obtenue entre la section de tuyau (10) conductrice électriquement et l'élément (50) de tuyau de couplage, et l'élément (76) de tuyau de voltmètre étant disposé de manière adjacente sur la section de tuyau (12) isolée électriquement de telle manière qu'une longueur de voltmètre ($I_{AK2}$) est obtenue entre l'élément (50) de tuyau de couplage et l'élément (76) de tuyau de voltmètre et une longueur de résistance ($I_{Ri}$) est obtenue entre l'élément (76) de tuyau de voltmètre et le système (2) électrique,
calculer la résistance d'isolement ($R_f$) de la tension de mesure ($U_m$) du signal de mesure, d'un courant de mesure ($I_m$) fourni, de la tension partielle ($U_i$), de la longueur de couplage ($I_{AK1}$), de la longueur ($I_{AK2}$) de mesure de tension et de la longueur de résistance ($I_{Ri}$).

12. Procédé de surveillance selon la revendication 11,
**caractérisé par**
une utilisation pour surveiller la résistance d'isolement (Rf) d'un système de convertisseur de puissance non mis à la terre.

13. Procédé accru pour surveiller une résistance d'isolement commune de plusieurs sous-systèmes (16) électriques non mis à la terre qui sont alimentés par un transformateur (15) commun et qui comprennent chacun un refroidissement des liquides qui est opéré à la terre en utilisant un fluide de refroidissement (3) et qui a une conduite d'alimentation (6) et une conduite de retour (8), la conduite d'alimentation (6) et la conduite de retour (8) étant chacune réalisée sous la forme d'une section de tuyau (10) conductrice électriquement qui est connectée à un potentiel de terre (PE) et à laquelle est connectée une section de tuyau (12) isolée électriquement qui est connectée au sous-système électrique (16) correspondant et qui a une longueur de tuyau ($I_i$),
**caractérisé en ce**
**qu'**au moins deux des sous-systèmes électriques (16) non mis à la terre sont surveillés en utilisant un procédé de surveillance d'une résistance d'isolement selon l'une quelconque des revendications 9 à 12 et les signaux de mesure sont couplés de manière synchrone dans les sous-systèmes électriques (16) à être surveillés au moyen d'un dispositif (18) de commande de synchronisation.

14. Procédé de surveillance accru selon la revendication 13,
**caractérisé en ce que**

les amplitudes des signaux de mesure sont commandées au moyen d'un dispositif (82) de commande d'amplitude.

Fig. 1

**Fig. 2**

**Fig. 3**

EP 3 872 503 B1

Fig. 4

Fig. 5

EP 3 872 503 B1

Fig. 6

**Fig. 7**

EP 3 872 503 B1

Fig. 8

Fig. 9

**Fig. 10**

Fig. 11

EP 3 872 503 B1

**Fig. 12**

EP 3 872 503 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016009346
- US 2009096464 A
- JP 2010164531 B